(19) Europäisches Patentamt / European Patent Office / Office européen des brevets

(11) **EP 4 293 365 B1**

(12) **EUROPÄISCHE PATENTSCHRIFT**

(45) Veröffentlichungstag und Bekanntmachung des Hinweises auf die Patenterteilung:
**24.04.2024   Patentblatt 2024/17**

(21) Anmeldenummer: **23179701.0**

(22) Anmeldetag: **16.06.2023**

(51) Internationale Patentklassifikation (IPC):
**G01R 19/25** (2006.01)   **G01R 31/69** (2020.01)

(52) Gemeinsame Patentklassifikation (CPC):
**G01R 31/69; G01R 19/2513;** G01R 27/16;
G01R 29/18

(54) **ANORDNUNG UND VERFAHREN ZUR ZUORDNUNG VON ANSCHLUSSPUNKTEN ZU SICHERUNGSKREISEN EINER ELEKTROINSTALLATION**

ARRANGEMENT AND METHOD FOR ASSIGNING CONNECTION POINTS TO CIRCUIT BREAKER CIRCUITS OF AN ELECTRICAL INSTALLATION

DISPOSITION ET MÉTHODE POUR L'ATTRIBUTION DES POINTS DE RACCORDEMENT AUX CIRCUITS DE PROTECTION D'UNE INSTALLATION ÉLECTRIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **17.06.2022   DE 102022115158**

(43) Veröffentlichungstag der Anmeldung:
**20.12.2023   Patentblatt 2023/51**

(73) Patentinhaber: **Schnabel, Werner**
**74821 Mosbach (DE)**

(72) Erfinder: **Schnabel, Werner**
**74821 Mosbach (DE)**

(74) Vertreter: **Scharfenberger, Burkhard**
**Pöhner Scharfenberger**
**Inh. Patentanwalt Dr. Burkhard Scharfenberger**
**Kaiserstraße 33**
**97070 Würzburg (DE)**

(56) Entgegenhaltungen:
**US-A1- 2010 085 894      US-A1- 2014 333 324**
**US-A1- 2016 274 174      US-B1- 9 354 256**
**US-B1- 9 857 414**

**Beschreibung**

Vorliegende Erfindung betrifft eine Anordnung und ein Verfahren zur Zuordnung von Anschlusspunkten einer Elektroinstallation zur Sicherungskreisen der Elektroinstallation, wobei die Anordnung zwei der mehr Messgeräte umfasst, von denen jedes Anschlussmittel zum Anschluss des jeweiligen Messgeräts an einen der Anschlusspunkte und Sendemittel aufweist.

Beim Erstellen der Elektroinstallation eines privaten oder gewerblichen Gebäudes werden die am Gebäudeanschlusspunkt ankommenden Dreiphasen der Versorgungsnetzspannung, kurz Netzspannung, erst zu einem zentralen Verteilerkasten geführt und von dort weiter auf die einzelnen Versorgungskreise des Gebäudes aufgeteilt. Jeder dieser Versorgungskreise ist durch mindestens eine Sicherung vor einer Überlastung geschützt, weswegen man auch von Sicherungskreisen sprechen kann. Die Sicherungskreise versorgen jeweils wiederum einen oder mehrere Anschlusspunkte an denen elektrische Verbraucher an die Elektroinstallation angeschlossen werden können. Anschlusspunkte sind beispielsweise Steckdosen, oder üblicherweise über Schalter, geführte Lampensockel oder auch Anklemmpunkte zum direkten Anklemmen von, üblicherweise stationären, Verbrauchern.

Die Aufteilung der einzelnen Anschlusspunkte auf die Sicherungskreis sowie die Aufteilung der Sicherungskreise auf die Phasen der Versorgungsspannung erfolgt bei Erstellen der Elektroinstallation durch den Elektroinstallateur. Häufig wird diese Zuordnung nicht oder nicht ausreichend dokumentiert. Selbst wenn eine Dokumentation, d.h. welcher Anschlusspunkt welcher Sicherung und welcher Phase zugeordnet worden ist, erstellt wurde, geht diese häufig verloren bzw. veraltet mit der Zeit wenn Änderungen an der Elektroinstallation vorgenommen werden.

Soll dann zu einem späteren Zeitpunkt einmal ein oder gar mehrere Verbraucher mit einer hohen Leitungsaufnahme an einen oder mehrere Anschlusspunkte der Elektroinstallation angeschlossen werden, steht man vor dem Problem, wie man erkennen kann, ob hierbei vielleicht eine Phase der Versorgungsspannung oder eine Sicherung der Elektroinstallation überlastet werden könnte. Dieses Problem stellt sich beispielsweise dann, wenn Trocknungsmaßnahmen nach einem Wasserschaden anstehen. Hierbei müssen üblicherweise mehrere Trockengeräte über die Elektroinstallation betrieben werden, wobei jedes der Trockengeräte für sich genommen bereits ein recht starker Verbraucher ist (die Leistungsaufnahme von Trockengeräten liegt häufig im Bereich von 2 Kilowatt oder mehr). Derartig leistungsstarke Verbraucher müssen gewissenhaft über die Phasen und Sicherungen aufgeteilt werden, damit die Versorgungsspannung nicht zu ungleichmäßig belastet, was die Versorgungsnetzstabilität beeinträchtigen kann, bzw. eine Sicherung nicht überlastet wird, was ein Brandrisiko mit sich bringen würde, was im Folgenden erläutert wird.

Denn zusätzlich stellt sich bei Anschluss von leistungsstarken Verbrauchern ebenfalls das Problem, dass, besonders bei älteren Elektroinstallationen, ein Leitungswiderstand oder ein Innenwiderstand zwar so hoch ist, dass der im Falle eines Kurzschlusses fließende Strom nicht ausreicht um eine Sicherung schnell auszulösen, aber nicht hoch genug ist um zu verhindern, dass ein die Leitung überlastender Strom fließt. Dies kann bei Altern der Elektroinstallation und der Korrosion von elektrischen Kontakten oder auch durch den unsachgemäßen Anschluss von Kontakten hervorgerufen werden.

Das Problem der Phasenzuordnung ist im Stand der Technik bekannt und wird besonders elegant durch eine Anordnung zur Phasen Identifikation gemäß der deutschen Patentanmeldung 10 2021 123 908.7 des Anmelders gelöst. Das Problem, die zu einem Sicherungskreis gehörende Sicherung zu identifizieren, wurde im Stand der Technik ebenfalls schon umfangreich behandelt und zahlreiche Lösungsvorschläge erarbeitet.

So schlägt das US Patent 4,121,152 für Hale et al. ein System aus pulsierender Last und ein Induktionsampèremeter vor, wobei die Last in eine interessierende Steckdose gesteckt oder mit einem anderen Anschlusspunkt verbunden wird, wo sie sodann einen pulsierenden Strom zieht. Die zu der dieser Steckdose oder diesem Anschlusspunkt gehörende Sicherung kann dann im Sicherungskasten dadurch identifiziert werden, dass man das Induktionsampèremeter nacheinander um alle zu den einzelnen Sicherung führenden Leitungen hält. Die gesuchte Sicherung ist dann anhand eines pulsierenden Signals des Ampèremeter erkennbar.

Eine ähnliche Lösung schlägt das US Patent 6,163,144 vor, nur das statt einer einfachen pulsierenden Last ein Transmitter zur Einspeisung eines niederfrequent modulierten Hochfrequenzsignals und statt eines Induktionsamperemeters ein entsprechendes zum Erkennen des Hochfrequenzsignals optimierter Empfänger eingesetzt wird.

Die US Patentanmeldung US 2016/0274174 A1 offenbart eine komplexere Lösung des Sicherungszuordnungsproblems, welche mehrere an den interessierenden Anschlusspunkten angeschlossenen Module umfasst, von denen jedes eine eigene ID in Form einer nicht zu großen natürlichen Zahl hat. Nach dem Einstecken bzw. Wiedereinschalten der Netzspannung durch Betätigung der Sicherung zählt jedes Modul die Nulldurchgänge der Spannung an seinen Anschlusspunkt und dasjenige Modul, welches als erstes seine ID Zahl erreicht wird aktiv und beginnt seine ID über den Außenleiter der Elektroinstallation zu senden , sodass das Signal am Sicherungskasten oder an einem anderen, am gleichen Sicherungskreis hängenden Anschlusspunkt empfangbar ist. Konkret wird empfohlen das Signal mit einem Handgerät am Sicherungskasten abzugreifen. Letzteres setzte aber voraus, dass die einzelnen Sicherungskreise während des Messvorgangs elektrisch voneinander getrennt sind, was bedeutet das alle Sicherungen außer des zu vermessenden auszuschalten sind. Somit wäre kein Vorteil vor der klassischen Methode des Durchprobierens aller Sicherungen gewonnen. Dabei ist ein Einsatz im laufenden Betrieb ersichtlich nicht möglich. In jedem Fall ist wie bei den anderen vorher vorgestellten Lösungen ein Zugang zum Sicherungskasten notwendig, sodass ein einzelner Arbeiter zwischen dem oder den interessierenden Anschlusspunkten des Sicherungskasten hin- und herlaufen muss, oder aber zwei Arbeiter von Nöten sind, welche sich gegebenenfalls auch über eine größere Distanz verständigen können müssen.

In der veröffentlichten US Patentanmeldung US 2007/0139055A1 wird eine Lösung des Sicherungszuordnungsproblems gezeigt, die ebenfalls mehrere Module einsetzt, welche im Unterschied zu vorhergehend präsentierten Lösung jedoch ihre jeweilige ID drahtlos an ein Empfangsgerät senden, wobei dieses Empfangsgerät an seiner Vorderseite eine Reihe von Lampen aufweist, die jeweils nur dann aufleuchten wenn das zugehörige Modul gerade sendet. Hiermit kann man die zu einer Sicherung gehörigen Anschlusspunkte also anhand der Sendemodule erkennen wenn nur diese Sicherung eingeschaltet ist.

Die Verwendung setzt also wie bei der klassischen Methode das Ausschalten aller gefolgt von dem sukzessiven Anschalten aller Sicherungen voraus. Der Vorteil der dortigen Lösung ist lediglich, dass ein Arbeiter vom Sicherungskasten aus bereits alle Anschlusspunkte kartieren kann, was aber voraussetzt, dass genügend Module vorhanden sind. Im realistischen Fall, dass die Zahl der Anschlusspunkte die Zahl Module (deutlich) übersteigt, ist weiterhin ein Hin- und Herwechseln des Arbeiters, oder aber der Einsatz weiterer Arbeiter nötig. Die Notwendigkeit des Zugangs zum Sicherungskasten und der Unterbrechung des laufenden Betriebs verbleiben ebenfalls als Nachteile.

Die Patentschrift US 9,552,446B2 präsentiert eine umfassende Lösung des Sicherungskreiskartierungsproblems, bei dem ein Benutzer zunächst mittels eines Computerprogrammes eine virtuelle Repräsentation des Sicherungskastens und eines Gebäude-/ Geschossplanes, auf den die Anschlusspunkte markiert sind, erstellt und dann Module mit den Anschlusspunkten verbindet, wobei die ID des jeweiligen Moduls auf dem dem Gebäude/ Geschossplan miteingetragen wird. Dann wird mit einer an einen Computer angeschlossenen Sonde nacheinander in jeden Sicherungskreis ein Signal eingespeist was von den angeschlossenen Modulen erfasst und zur Ermittlung von Informationen über den Sicherungskreis verwendet wird. Auch diese Methode setzt also Zugang zum Sicherungskasten und ein sequentielles Schalten der Sicherungen voraus.

In den veröffentlichten internationalen Patentanmeldungen WO99/61928 und WO00/26679 wird ein System zur Lokalisierung von Sicherungen beschrieben, bei welchem ihr Sicherungskreis über einen permanenten Identifikationsschaltkreis verfügt, welche beim Erfassen eines Signals eine bestimmte Frequenz auslöst.

Beim Anschließen eines Transmitters, welcher genau diese Frequenz in die Drähte des Sicherungskastens einspeist, leuchtet am Identifikationsschaltkreis eine Lampe auf. Ein Bannpassfilter in dem Identifikationsschaltkreis verhindert ein Überspringen des Transmittersignals auf andere Sicherungskreise. Dieses System ist durch die permanenten Identifikationsschaltkreise sehr aufwendig und dadurch auch ersichtlich nicht für eine spontane Ermittlung der Sicherungskreiszuordnung geeignet.

Die Patentschrift US 8,018,219 B2 stellt ein System aus zwei oder mehr Modulen vor, welches für die gegenüber einer vollen Sicherungszuordnung reduzierten Aufgabe, für zwei oder mehr interessierende Anschlusspunkte zu entscheiden, ob diese zum selben oder verschiedenen Sicherungskreisen gehören, besser geeignet ist, als die bisher vorgestellten Systeme. Nach der dortigen Lehre werden die Module in die interessierenden Steckdosen eingesteckt. Nach einer Benutzereingabe auf einem der Module speist dieses ein durch einen Signalgenerator des Moduls erzeugtes spannungs- oder frequenzmoduliertes Signal in die Steckdose, in die es eingesteckt ist, ein. Alle Module, welche dieses Signal empfangen, zeigen dies mittels auf ihrer Vorderseite vorhandener Anzeigemittel an. Zugehörigkeit zu gleichen oder verschiedenen Sicherungskreisen ist daher auch bei diesem System nur dann eindeutig entscheidbar, wenn die Sicherungskreise elektrisch voneinander getrennt werden. Will man vermeiden, nacheinander alle Sicherungen auszuprobieren, was der klassischen technologiefreien Lösungsmethode entspricht, muss ein den Sicherungen vorgeschalteter Verzweigungspunkt geöffnet werden. Insofern ist auch bei dieser Anordnung ein Zugang zum Sicherungskasten nötig und eine Überprüfung bei laufenden Betrieb unmöglich.

In der Offenlegungsschrift US 2014/0333324 A1 und in der Patentschrift US 9,857,414 B1 wird vorgeschlagen, den Betrieb von an einer Elektroinstallation angeschlossenen elektrischen Geräten indirekt zu überwachen indem Überwachungseinheiten mit Anschlusspunkten der Elektroinstallation verbunden werden, wobei die Überwachungseinheiten die an dem Anschlusspunkt abgreifbare Spannung überwachen und, nach einer Kalibrierung mit bekannten Lasten, die an bekannten Punkten an die Elektroinstallation angeschlossen werden, aus Änderungen der Spannung die von den Elektrogeräten verbrauchte Leistung ableiten.

In der Offenlegungsschrift US 2010/0085894 A1 wird eine Vorrichtung, ein System und ein Verfahren zum Erstellen von Elektrischen Schaltbildern eines elektrischen Netzwerks bzw. einer Elektroinstalltion offenbart, bei dem schaltbare Lasten an bekannten Punkten aufgeschaltet und der resultierende Leistungsfluss gemessen und daraus das gewünschte Schaltbild abgeleitet wird.

In der Patentschrift US 9,354,256 B1 wird ein Testgerät für elektrische Schaltungen vorgestellt, welchs einen Stromwandler umfasst, mittels dessen eine variable Last in einem benachbarten Schaltkreis detektiert werden kann. Die Detektion einer variablen Last wird dem Testgerät und einer Lastdetektionsfunktion mitgeteilt.

Vor diesem Hintergrund hat sich vorliegende Erfindung die Aufgabe gestellt, eine verbesserte Anordnung zur Durchführung einer Zuordnung von Anschlusspunkten zu Sicherungskreisen einer Elektroinstallation aufzufinden, welche bei einfacher und unkomplizierter Handhabung die vorbeschriebenen Nachteile überwindet und insbesondere ohne Zugang zum Sicherungskasten auch bei laufendem Betrieb eingesetzt werden kann.

Gelöst wird diese Aufgabe durch eine Anordnung gemäß Anspruch 1, und ein Verfahren gemäß Anspruch 14.

Die Anordnung umfasst dabei mindestens zwei, bevorzugt auch mehr, insbesondere drei, vier oder fünf, Messgeräte, von denen jedes über Anschlussmittel an ein Anschlusspunkt der Elektroinstallation, Belastungstestmittel einschließlich Spannungs- und Strommessmittel zum Durchführen eines Belastungstests und auf Aufzeichnen von dabei gemessenen Spannungswerten einer am Anschlusspunkt anliegenden Spannung sowie eines den Anschlusspunkt durchfließenden Stromes und Datenaustausch- oder -sendemitteln, um mit anderen Messgeräten oder einem weiteren Gerät, beispielsweise einem zentralen Steuer- bzw. Kontrollgerät die Messergebnisse auszutauschen.

In der Anordnung ist wenigstens auch ein Gerät vorhanden, welches über Auswertemittel zur Auswertung der bei den Belastungstests gewonnenen Spannungs- und Strommesswerten ausgestattet ist, wobei diese Auswertung zumindest die gewünschte Zuordnung der Anschlusspunkte zu einem Sicherungskreis der Elektroinstallation vorgenommen wird.

Ohne Zugang zum Sicherungskasten kann diese Zuordnung eine konkrete Zuweisung von Anschlusspunkt zu einer bestimmten, im Sicherungskasten identifizierten Sicherung verstanden werden, sondern unter Zuordnung ist eine relative Zuordnung gemeint, bei der der Benutzer der Anordnung eine Rückmeldung darüber erhält, welche der mithilfe der Anordnung ermessenen interessierenden Anschlusspunkte im gleichen Sicherungskreis liegen, und welche in verschiedenen Sicherungskreisen liegen. Für die eingangs betrachteten Einsatzszenarien bei denen Anschlusspunkten in verschiedenen Sicherungskreisen zum Anschluss leistungsstarker Verbraucher gesucht werden, ist diese Information ausreichend.

Das mit den Auswertemitteln ausgestattete Auswertegerät verfügt zudem über Anzeigemittel, mit Hilfe derer ein Benutzer die Auswerteergebnisse einschließlich vor allem der ermittelten Sicherungskreiszuordnung der vermessenen Anschlusspunkte angezeigt werden. Dass Auswertegerät verfügt darüber hinaus zumindest über Mittel zum Empfangen der von den Messgeräten versendeten Messdaten. Darüber hinaus kann es auch selbst mit Datensendemitteln ausgestattet sein, um Steuerkommandos oder andere Informationen an die Messgeräte weiterzugeben. Dass Auswerte- bzw. Steuergerät kann ein separates Gerät der Anordnung sein, beispielswese ein tragbares, mit den Messgeräten über Funk kommunizierendes Gerät. Alternativ kann es sich hierbei um eines der Messgeräte handeln, welches also zusätzlich zu den Auswerte- und Anzeigemitteln auch die Anschlussmittel zur Verbindung mit einem Anschlusspunkt sowie die Belastungstestmittel aufweist, In manchen Ausführungsformen der Erfindung sind alle Messgeräte gleichartig ausgestaltet, das heißt sie verfügen alle über Auswerte- sowie Anzeigemittel, und welches als Steuergerät dient bestimmt sich dadurch, von welchem Gerät aus der Benutzer seine Eingaben vornimmt.

Nach dem erfindungsgemäßen Verfahren werden zwei oder mehr der vorbeschriebenen Messgeräte zunächst mit je einem interessierenden Anschlusspunkt verbunden. Sodann wird nach dem Eintreten eines Startereignisses mithilfe von Koordinationsmitteln ein Belastungstestzeitplan erstellt. Der Belastungstestzeitplan umfasst eine Liste von Messzeitfenstern, von denen jedes einem Messgerät zugeordnet ist. Ein Messzeitfenster wird definiert durch ein Anfangszeitpunkt und eine Dauer oder ein Anfangszeitpunkt und einen Endzeitpunkt. Die Zeiten können hierbei in Form üblicher Zeiteinheiten, d. H Sekunden oder Millisekunden gegeben sein, oder sie sind in Form einer Anzahl von null Durchgängen der am Anschlusspunkt anliegenden Wechselspannung angegeben. Der Belastungstestzeitplan kann allen Messgeräten mitgeteilt werden oder jedes der Messgeräte erhält lediglich die Angaben über die ihm zugeordneten Messzeitfenster.

Die Koordinationsmittel können auch zu Beginn eines Messdurchgangs dafür, dass eine gemeinsame Zeitbasis aller an der Messung teilnehmenden Messgeräte etablieren. Hierbei werden beispielsweise interne Zeitmesser bzw. Uhren der Messgeräte synchronisiert oder es wird ein interner Nulldurchgangszähler aller Messgeräte auf dem gleichen Wert, beispielsweise null gesetzt, damit jedes der teilnehmenden Messgeräte die ihm zugeteilten Messzeitfenster korrekt wahrnehmen kann. Dies empfiehlt sich in Ausführungsformen, in denen die Messgeräte selbsttätig die es betreffenden Messzeitfenster abarbeiten, also über Beginn und Ende eines Belastungstests entscheiden. Alternativ kann auch durch das Koordinationsmittel eines zentralen Steuergeräts oder eine Steuerfunktion wahrnehmenden Messgeräts jedem der anderen, gesteuerten Messgeräte Beginn und Ende einer Belastungstestmessung vorgeben werden.

Sodann werden durch die Messgeräte dem Messzeitplan folgend Belastungstests durchgeführt und die dabei ermittelten Spannungs- und Stromwerte aufgezeichnet. Bei einem Belastungstest schaltet ein Messgerät für die Dauer des Messzeitfensters eine definierte Testlast auf den Anschlusspunkt, und misst den dabei fließenden Strom sowie die sich bei diesem Strom einstellende, am Anschlusspunkt anliegende Spannung. Diese Spannung wird gegenüber der Spannung bei offenem Stromkreis/unendlicher Last, also außerhalb des Belastungstests, einen Spannungsabfall ΔU aufweisen. Alternativ oder zusätzlich zum Absolutwert er gemessenen Spannung bei Belastung kann auch dieser Spannungsabfall ΔU aufgezeichnet werden. Sowohl die gemessene Spannung als auch der Spannungsabfall ΔU wird während eines Zeitfensters eines Belastungstests nicht lediglich bei einem bestimmten Zeitpunkt, beispielsweise in der Mitte des Zeitfensters, gemessen und aufgezeichnet, sondern es wird der Verlauf der Spannung bzw. des Spannungsabfalls während des gesamten Zeitfensters bestimmt. Dies kann dadurch geschehen, dass das Zeitfenster in ein feines Zeitraster unterteilt und zu jedem Zeitpunkt des Rasters ein Messwert bzw. ein Paar von Messwerten aufgezeichnet wird. Alternativ oder bei einer Nachbearbeitung der wie vorbeschriebenen aufgezeichneten Rohdaten kann auch die in einem Zeitfenster aufgezeichnete Datenmenge dadurch reduziert werden, dass lediglich signifikante Änderungen in den Messwerten zusammen mit dem Zeitpunkt, zu dem sie eingetreten sind, aufgezeichnet werden. Signifikant bedeutet hier wie auch im Folgenden eine bestimmte Genauigkeit bzw. Präzision der jeweiligen Größe übersteigende Änderung. Kann das Messgerät beispielsweise Spanungswerte bzw. Spannungsabfallwerte mit einer Genauigkeit von plus minus 10 Millivolt aufzeichnen, so sind alle Spannungsänderungen größer als zehn Millivolt signifikant. Die für die vorgeschriebene Nachbearbeitung oder Messdatenreduktion angewandte Signifikanzschwelle kann gleich der intrinsischen Messgenauigkeit des Messgeräts verwendeten Spannungs- bzw. Strommessmittel gewählt sein, kann sich aber auch von dieser unterscheiden und einen größeren, beispielsweise einen 2, 3, 4 oder 10-fach größeren Wert haben. So könnte beispielsweise ein Messgerät physikalisch in der Lage sein, Spannungswerte mit einer Genauigkeit von plus minus 10 Millivolt zu messen, die für eine Analyse signifikante Änderung der gemessene Spannungsabfallwerte oder absoluten Spannung angewandte Signifikanzschwelle jedoch auf 100 Millivolt gesetzt werden, sodass lediglich Änderungen von mehr als 100 Millivolt in den aufgezeichneten oder Nachbearbeiteten Messdaten eines Messzeitfensters verzeichnet werden. Die Signifikanzschwelle kann in dem Auswertemittel fest vorgegeben, etwa einprogramm oder verdrahtet und nicht änderbar sein. Alternativ ist ein vorgegebener Standartwert für die Signifikanzschwelle vom Benutzer abänderbar.

Die an den Anschlusspunkten gemessene Spannung ist eine Wechselspannung, weswegen sich der instantane Spannungswert während des Messzeitfensters (periodisch) ändert. Aufgezeichnet wird bevorzugt nicht das sicher periodisch ändernde Spannungssignal, sondern lediglich Messwerte zu bestimmten Phasenwinkeln, etwa 90° und/oder 270° entsprechend den Extremwerten der Spannung. Das Messergebnis des Messzeitfenster ergibt sich dann als Mittelung über die aufgezeichneten Spannungs- bzw-. Spannungsabfallsmesswerte. Diese Mittelung kann auch intrinsisch durch Einsatz eines ausreichend trägen Spannungsmessmittels erfolgen.

Die Messgeräte zeichnen jedoch nicht nur während eigener Belastungstests die Spannungs- bzw. Spannungsabfallwerte auf, sondern erfindungsgemäß währende des gesamten Messvorgangs, d. H. während der gesamten Abarbeitung des Belastungstestzeitplans. Hierdurch stehen für die Auswertung zu jedem Zeitpunkt des Belastungstestzeitplans (gemittelte) Messdaten aller teilnehmenden Messgeräte zur Verfügung, was für die Ermittlung der gewünschten Sicherungskreiszuordnung der vermessenen Anschlusspunkte wesentlich ist.

Spätestens nach dem Ende eines Belastungstestdurchgangs, d. H. nach Abarbeiten des jeweiligen Belastungstestzeitplans durch die Messgeräte, leiten letztere die von Ihnen während des gesamten Durchgangs aufgezeichneten Messdaten für Strom und Spannung an ihren jeweiligen Anschlussunkt den Auswertemitteln zu. Durch Vergleich der Messwerte, insbesondere durch Vergleich der Spannungsabfallwerte an den einzelnen Anschlusspunkten während der verschiedenen Belastungstests, welche sich auch zeitlich überlappen können, ermitteln die Auswertemittel die gewünschte Sicherungskreiszuordnung sowie in manchen vorteilhaften Ausführungsformen auch weitere Informationen über die Elektroinstallation und die vermessenen Anschlusspunkte.

Konkret kommen hierbei, alleine oder gemeinsam, zwei Methoden zum Einsatz. Bei beiden Methoden teilt die Auswertemittel den Belastungstestzeitraum in Zeitabschnitte ein, wobei ein Abschnitt durch die in diesem Zeitabschnitt einen Belastungstest durchführenden Messgerät charakterisiert ist. Beispielsweise kann zunächst ein Messgerät an einen ersten Anschlusspunkt seinen Belastungstest beginnen, welcher insgesamt 100 Millisekunden andauert, und nach dem 50 Millisekunden vergangen sind, beginnt auch ein weiteres Messgerät an einem zweiten Anschlusspunkt einen Belastungstest von gleicher Gesamtdauer. Dann teilen sich die Zeitfenster der beiden Messgeräte am ersten und zweiten Anschlusspunkt in drei Abschnitte ein von jeweils fünfzig Millisekunden Dauer ein: ein ersten Abschnitt, in dem lediglich das erste Messgerät einen Belastungstest durchführt, einen zweiten Abschnitt in dem sowohl das erste als auch das zweite gleichzeitig einen Belastungstest durchführen, und einen dritten Abschnitt in dem das erste Messgerät seinen Belastungstest schon beendet hat, das zweite jedoch noch weiter einen Belastungstest durchführt.

Erweitert man dieses Beispiel um ein drittes Messgerät an einem dritten Anschlusspunkt, dass nach 75 Millisekunden ab dem Zeitpunkt, an dem das erste Messgerät seinen Belastungstest begonnen hatte, seinen Belastungstest von ebenfalls 100 Millisekunden beginnt, so weitet sich die Zahl der zu betrachtenden Zeitabschnitte auf fünf: einen ersten von 50 Millisekunden in dem lediglich das erste Messgerät aktiv ist, einen zweiten, daran anschließenden von 25 Millisekunden in dem das erste und das zweite Messgerät Belastungstests an ihren jeweiligen Anschlusspunkten durchführen, einen dritten, daran anschließenden von ebenfalls 25 Millisekunden, in den alle drei Messgeräte gleichzeitig aktiv sind, einen vierten von 50 Millisekunden, in dem das zweite und dritte Messgerät gleichzeitig Belastungstests durchführen sowie einen fünften und letzten von 25 Millisekunden in dem lediglich das dritte Messgerät aktiv ist.

In manchen Ausführungsformen erfolgt die Auswertung so, dass das oder die Auswertemittel für jeden Zeitabschnitt vergleicht/vergleichen, welcher Spannungsabfall an den einzelnen Anschlusspunkten auftrat und verknüpfen diese Informationen mit denen die im diesen Zeitabschnitt aktiven, d. H. einen Belastungstest durchführenden, Messgeräten. Hierbei werden alle Anschlusspunkte, welche einen signifikanten, d. H. innerhalb der vorgegebenen Genauigkeit von null verschiedenen oder oberhalb einer, vorgegebenen oder vom Benutzer gewählten, Signifikanzschwelle liegenden, Spannungsabfall aufweisen, den gleichen Anschlusspunkten zugeordnet, wie der Anschlusspunkt desjenigen Messgeräts, welches zu dieser Zeit aktiv ist.

Hierdurch ergibt sich für jeden Zeitabschnitt eine Menge von Anschlusspunkten, welche den gleichen Sicherungskreis zugeordnet sind, sowie eine komplementäre Menge von Anschlusspunkten, die entweder einem anderen Sicherungskreis zuzuordnen sind, oder deren Zuordnung aufgrund der in dem Zeitpunkt aufgenommenen Daten nicht möglich ist. Die für die einzelnen Zeitabschnitte erfolgten Zuordnungen werden dann miteinander Verknüpft, indem Anschlusspunkte, die nach einer Mehrzahl der Tests als zusammengehörig identifiziert wurden, auch im endgültigen Auswerteergebnis dem gleichen Sicherungskreis zugeordnet werden. Da jedem der Messgeräte zumindest ein Zeitfenster im Belastungstestzeitplan zugeordnet war, sind für eine endgültige Zuordnung in jedem Fall genug Daten vorhanden.

Nach der zweiten Methode findet die Sicherungskreiszuordnung nicht nur nach einer qualitativen verknüpfenden Betrachtung der gemessenen Spannungsabfallwerte statt, sondern es wird für jeden Zeitabschnitt aus den für diesen Zeitabschnitt vorhandenen Daten unter Verwendung der ebenfalls aufgezeichneten Strommesswerte Leitungswiderstände von Paaren, Tripeln usw., allgemein für alle Teilmengen der beteiligten Anschlusspunkte berechnet. Der gemeinsame Leitungswiderstand repräsentiert hierbei den Widerstand in den zu dem Anschlusspunkt führenden Zuleitungen der Elektroinstallation der durch gemeinsame Leitungsabschnitte, d. H. Leitungsabschnitte welche ein vom Sicherungskasten zu dem jeweiligen Anschlusspunkten fließenden Strom auf den Weg zu jedem der in der betrachteten Teilmenge enthaltenen Anschlusspunkte in jedem Fall durchqueren muss. Der gemeinsame Leitungswiderstand ist also en Maß dafür, wie weit oder wie nah, hinter dem Sicherungskasten sich die Zuleitung zu den Verschiedenen Anschlusspunkten der betrachteten Teilmenge verzweigen. Ein vergleichsweise hoher gemeinsame Leitungswiderstand deutet darauf hin, dass diese Verzweigungsstelle recht weit hinter dem Sicherungskasten liegt, und somit eine vergleichsweise lange gemeinsame Zuleitung zu den Anschlusspunkten existiert. Umgekehrt deutet ein niedriger gemeinsamer Leitungswiederstand darauf hin, dass die Verzweigung schon recht früh hinter dem Sicherungskasten erfolgt.

Unter idealen Bedingungen würde man für zwei oder mehr in verschiedenen Sicherungskreisen liegenden Anschlusspunkte einen gemeinsamen Leitungswiderstand von 0 Ohm erwarten. Auch wenn der tatsächliche Messwert aufgrund von Messunsicherheiten in der Praxis nicht bei exakt 0 Ohm liegt, sollte doch bei Verwendung einer ausreichend hohen Signifikanzschwelle und einer ausreichenden Belastungstestdauer ein innerhalb dieser vorgegebenen Signifikanzschwelle nicht von null zu unterscheidender Wert gemessen werden.

Die Zuordnung von Anschlusspunkten zu Sicherungskreisen erfolgt nun nach der zweiten Methode anhand der für jeden Belastungstestzeitabschnitt ermittelten gemeinsamen Leitungswiderständen in der Art, dass diejenige, alle Anschlusspunkte umfassende Menge von disjunkten Teilmengen der Anschlusspunkte als Zuordnung ausgewählt wird, bei der der minimale, einer der Teilmengen der Menge zugeordnete gemeinsame Leitungswiderstand maximal ist. Insbesondere ist davon auszugehen, falls eine Teilmenge einer betrachteten Menge ein gemeinsamer Leitungswiederstand aller darin enthaltenen Anschlusspunkte von 0 aufweist, zu mindestens einer der Anschlusspunkte falsch zugeordnet ist, d. H in einem anderen Sicherungskreis liegt. Für eine korrekte Zuordnung wäre daher zu erwarten, dass alle Teilmengen der betrachteten, alle Anschlusspunkte abdeckende Ergebnismenge einen signifikant von null verschiedenen Leistungswiederstand aufweisen. Der gemeinsame Leitungswiderstand einer Teilmenge, welche lediglich ein Einzelanschlusspunkt enthält, ist notwendigerweise gleich dem Widerstand des Anschlusspunkts selbst, und repräsentiert den gesamten Widerstand auf dem Weg vom Sicherungskasten durch alle Außenleiter der Elektroinstallation bis zu diesem Anschlusspunkt inklusive der Übergangswiderstände an Klemmpunkten.

Im einfachsten Fall wird im Rahmen eines Belastungstestzeitplans jedem teilnehmenden Messgerät genau ein Messzeitfenster zugeordnet, welches mit keinem anderen Messzeitfenster überlappt. D.h. jederzeit während des Messdurchgangs findet höchstens genau ein Belastungstest statt. Um die Gesamtdauer des Messdurchgangs d. H des Belastungstestzeitplans zu minimieren, können und sollten bevorzugt die Belastungstestzeitfenster unmittelbar aneinander anschließen. D.h. sobald eines der Messgeräte seinen Belastungstest beendet beginnt das nächste Messgerät seinen Belastungstest.

Häufig liefert bereits ein solcher überlappungsfreier Belastungstestzeitplan ausreichende Daten zur eindeutigen Zuordnung aller Anschlusspunkte zu einem Sicherungskreis. Im Falle eines sich recht früh verzweigenden Sicherungskreises, könnten aber in verschiedenen Zweigen dieses Kreises liegende Anschlusspunkte fälschlicherweise als zu verschiedenen Sicherungskreisen gehörig identifiziert werden. Um dies soweit möglich auszuschließen, schlägt vorliegende Erfindung daher vor, in bevorzugten Ausführungsformen entweder von Anfang an oder aber bei Vorliegen eines bestimmten Kriteriums ein (weitere) Belastungstest-Messdurchgang durchzuführen, bei welchem Messzeitfenster überlappen. In diesem Fall sind während des Überlappungsabschnittes also zwei oder mehr der Messgeräte gleichzeitig aktiv.

Für die Zuordnung zu den Sicherungskreisen ist es dann entscheiden, ob bzw. welche der Anschlusspunkte in dem Überlappungszeitraum im Vergleich zu den Zeiträumen, in denen jeweils nur eines der Messgeräte aktiv ist, einen signifikanten Sprung des Spannungsabfalls aufweisen. Sofern zumindest ein kurzes gemeinsames Leitungsstück vorhanden ist, ist nämlich bei Anschlusspunkten im gleichen Sicherungskreis ein solcher Sprung zu erwarten, da der zu den anderen Anschlusspunkten in diesem Sicherungskreis, welche gleichzeitig ein Belastungstest durchführen, fließende Strom auch über dieses gemeinsame Leitungsstück fließen muss und somit an dem anderen Anschlusspunkt zu einem Spannungsabfall führt, welcher bei Verwendung der gleichen Test Last für beide aktive Anschlusspunkte, im Wesentlichen zirka das doppelte des Spannungsabfalls im Falle der Aktivität lediglich eines Messgerätes beträgt. Jedoch zeigen nicht nur nicht aktive Anschlusspunkte in dem Falle, dass sie dem gleichen Sicherungskreis zugehörig sind, wie die Anschlusspunkte gleichzeitig aktiver Messgeräte, einen erhöhten Spannungsabfall, sondern dies gilt auch für Anschlusspunkte aktiver Messgeräte selbst.

Die erfindungsgemäße Anordnung, genauer die Auswertemittel sind daher bevorzugt weiterhin dazu vorbereitet, zwei Anschlusspunkte, welche bei einem gleichzeitigen Belastungstest der mit ihnen verbundenen Messgeräte einen höheren Spannungsabfall aufweisen als bei den jeweiligen Einzeltests dem gleichen Sicherungskreis zuzuordnen.

Darüber hinaus können die Auswertungsmittel dazu vorbereitet sein, einem Anschlusspunkt, der bei einem gleichzeitigen Belastungstest zweier oder mehr anderer, dem gleichen Sicherungskreis zugehöriger, Anschlusspunkte dem gleichen Sicherungskreis zuzurechnen wie diese beiden oder mehr andere Anschlusspunkte.

Das Ergebnis der Auswertung wird dem Benutzer erfindungsgemäß durch das Auswertegerät d. H. ein zentrales Steuergerät oder einem der Messgeräte, angezeigt.

Im einfachsten Fall lediglich zweier interessierender Anschlusspunkte kommt eine Anordnung aus zwei Messgeräten zum Einsatz, von denen jedes mit einem der Anschlusspunkte verbunden wird. Nach Vorliegen des Startkriteriums, welches durch das Anschließen selbst oder auch durch Betätigung eines entsprechenden Bedienelementes auf einem der Messgeräte oder einem Steuergerät gesetzt werden kann, wird durch das Koordinationsmittel der Messgeräte oder des Steuergerätes ein Belastungstestzeitplan erstellt welcher für jedes der Messgeräte ein Testzeitfenster aufweist. Diese Testzeitfenster können disjunkt sein oder sich überlappen. Die Messgeräte führen dann entsprechend des Zeitplans Belastungstests durch. Die Messergebnisse für die Spannung und Stromwerte an den Anschlusspunkten werden im Laufe der Dauer des Messdurchgangs der Auswerteeinheit zugeleitet.

In den hier betrachteten einfachen Fall werden die beiden Anschlusspunkte dem gleichen Sicherungskreis zugeordnet, falls der Anschlusspunkt des nicht aktiven Messgerätes während des Belastungstests des anderen Messgerätes einen signifikanten Spannungsabfall zeigt. Im Folgenden wird dies als wechselseitiger signifikanter Spannungsabfall bezeichnet.

Um auch Zugehörigkeit zum gleichen Sicherungskreis in dem Fall zu erkennen, dass die zu den jeweiligen Anschlusspunkten führenden Außenleiter sich bereits vergleichsweise kurz hinter dem Sicherungskasten verzweigen, wird vorgeschlagen, sich überlappende Belastungstestzeitfenster vorzusehen. Während des Zeitabschnitts, in dem beide Geräte gleichzeitig einen Belastungstest durchführen, wird bei Zugehörigkeit zum gleichen Sicherungskreis ein zusätzlich erhöhter Spannungsabfall gemessen werden. Dieser zusätzliche Belastungstest mit sich überlappenden Testzeitfenstern der beiden beteiligten Anschlusspunkte kann von vornherein d. H. im ersten Messdurchgang, eingeplant werden. Alternativ kann er nachträglich von der Auswerteeinheit vorgeschrieben und mittels der Koordinationsmittel koordiniert werden, falls die Messergebnisse des ersten Durchgangs keine eindeutige Zuordnung erlaubt.

Dies kann beispielsweise abhängig davon entschieden werden, ob die gemessenen wechselseitigen Spannungsabfälle, also die Spannungsabfälle des jeweils nicht aktiven Anschlusspunktes, in einem Zwischenbereich nur knapp über der Signifikanzschwelle liegt. Wird beispielsweise seitens der Auswerteeinheit in der Auswertung der Belastungstestmessergebnisse mit einer Signifikanzschwelle von 100 mV gearbeitet, oberhalb derer ein möglicherweise von signifikanter Spannungsabfall vorliegt, so kann eine zweite, höhere Signifikanzschwelle definiert werden, beispielsweise 200 mV. Wird ein Spannungsabfall zwischen der ersten und zweiten Signifikanzschwelle, im vorgenannten Beispiel also zwischen 100 und 200 mV gemessen, so kann die Auswerteeinheit entscheiden, einen weiteren Belastungstest mit sich überlappenden Testzeitfenstern durchzuführen, um die verbleibende Restunsicherheit hinsichtlich der korrekten Zuordnung zu verringern. Zeigt sich bei dem zweiten Messvorgang bei gleichzeitiger Belastungstestmessung an beiden Anschlusspunkten kein zusätzlicher Spannungsabfall, also kein gegenüber der ersten Messung erhöhter Spannungsabfall, so wird entschieden, dass die beiden Anschlusspunkte in verschiedenen Sicherungskreisen liegen. Im gegenteiligen Fall eines signifikant erhöhten Spannungsabfalles, folgt das gegenteilige Auswertungsergebnis, dass die beiden Anschlusspunkte im gleichen Sicherungskreis liegen müssen.

Durch die erfindungsgemäße Anordnung ist es dem Benutzer möglich, auf einfache und intuitive Weise die Zuordnung von zwei oder mehr Anschlusspunkten zu den Sicherungskreisen der Elektroinstallation, beispielsweise eines Gebäudes oder Schiffes, zu finden, ohne Zugang zum Sicherungskasten zu benötigen und auch ohne den laufenden Betrieb der angeschlossenen Geräte zu beinträchtigen. Die bei dem Belastungstest auf die Anschlusspunkte geschaltete Last, wird ausreichend hoch gewählt, um eine Überlastung der Sicherung nahezu auszuschließen. Hierzu beträgt die Last bevorzugt zwischen 20 und 2000, besonders bevorzugt zwischen 100 und 200 Ohm. Im Gegensatz zu bekannten Sicherungskreisanordnungen ist somit eine Sicherungskreiszuordnung für alle Anschlusspunkte der Elektroinstallation durch ein einzelnen Arbeiter oder Benutzer in kurzer Zeit und ohne weitere Hilfsmittel möglich.

Weitere vorteilhafte Weiterbildungen sind den abhängigen Ansprüchen zu entnehmen und sollen nachfolgend im Einzelnen vorgestellt werden. Für den Fachmann ist es ersichtlich, dass sie grundsätzlich, auch wenn nicht ausdrücklich erwähnt, beliebig miteinander kombiniert werden können, sofern sie sich technisch nicht gegenseitig ersichtlich ausschließen.

In bevorzugten Ausführungsformen der Erfindung ist das oder sind die Anschlussmittel ein Stecker, beispielsweise die in Deutschland gebräuchlichen Euro- oder Typ F Schuko-Stecker. Das Anschlussmittel kann auch ein in eine Lampenfassung eindrehbares Gewinde oder ein paar Anschlussklemmen, beispielsweise Krokodilklemmen, sein. Die Messgeräte können jeweils über ein einzelnes Anschlussmittel, oder in weiterhin bevorzugten Ausführungsformen über verschiedene Anschlussmittel verfügen. Besonders bevorzugt sind die Anschlussmittel austauschbar gestaltet, sodass ein Messgerät je nach Einsatzzweck und dem zu vermessenen Anschlusspunkt vor Ort vorbereitet werden kann.

Die Belastungstestmittel der Messgeräte der erfindungsgemäßen Anordnung umfassen in weiterhin bevorzugter Ausführungsform eine steuerbare Last in Form eines elektronischen oder elektrischen Schalters, beispielsweise eines Transistors, Thyristors, einer Zweirichtungs-Thyristordiode (TRIAC) oder eines Relais. Eine Steuereinheit des Messgeräts überwacht die seit Eintreten eines Startkriteriums vergangene Zeit und schaltet zum richtigen Zeitpunkt die steuerbare Last auf den Anschlusspunkt um den Belastungstest zu beginnen. Beim Erreichen des Endzeitpunkts oder Ablauf der vom Belastungstestzeitplan vorgegebenen Dauer des Belastungstests dieses Anschlusspunktes wird der Schalter wieder Deaktiviert und der Belastungstest beendet.

Die Koordinationsmittel der erfindungsgemäßen Anordnung ermöglichen die Erstellung von Belastungstestzeitplänen, wobei zumindest in einem ersten Messdurchgang jedem beteiligten Anschlusspunkt mindestens ein Messzeitfenster zugeordnet wird. In nachfolgenden Messdurchgängen können auch nur einem Teil, im Minimalfall lediglich einem, der Anschlusspunkte ein Messzeitfenster zugeordnet werden.

Die Koordinationsmittel können entweder in einem zentralen Steuergerät untergebracht sein, welches nach der Aktivierung über einen Sendeempfänger eine Anfrage nach erreichbaren Messgeräten sendet und alle antwortenden Messgeräte in einer Messgeräteliste registriert. Die Liste kann periodisch aktualisiert werden, um abgeschaltete oder vom jeweiligen Abschlusspunkt getrennte Messgeräte auszutragen um sie bei zukünftigen Belastungstests nicht mehr zu berücksichtigen. Hierdurch wird vermieden, dass nicht mehr aktiven Messgeräten ein Zeitfenster in einem Belastungstestzeitplan zugeordnet wird.

Alternativ können Koordinationsmittel auch in jedem der Messgeräte integriert sein, und eines der Messgeräte wird als ein Steuergerät ausgewählt.

Weiterhin alternativ kann das Koordinationsmittel auch über die Messgeräte verteilt unter Einsatz von Peer-to-Peer Koordinationsmechanismen realisiert werden.

Bei dem Steuergerät kann es sich bei manchen Ausführungsformen um ein separates Gerät handeln, welches nicht selbst mit einem Anschlusspunkt verbunden ist oder auch gar nicht über Anschlussmittel verfügt. Alternativ ist das Steuergerät ebenfalls als Gerät ausgestaltet und ist dementsprechend mit Anschlussmitteln sowie Belastungstestmitteln versehen. Bevorzugt kann das Steuergerät seine Funktion jedoch auch wahrnehmen, wenn es nicht selbst mit einem Anschlusspunkt verbunden ist.

Die Datensendemittel der einzelnen Messgeräte umfassen bevorzugt einen Senderempfänger für die Übertragung von Daten. Der Senderempfänger der Messgeräte, sowie auch der Sendeempfänger des Steuergerätes, falls vorhanden, können drahtgebunden arbeiten. Bevorzugt erfolgt hierbei der drahtgebundene Datenaustausch über die Außenleiter der Elektroinstallation selbst. D.h. die Senderempfänger speisen ein die entsprechenden Daten kodierendes Signal direkt in den Außenleiter der Elektroinstallation ein. Ein erfolgreicher Datenaustausch setzt dabei also voraus, dass alle zu vermessende Datensicherungskreise elektrisch miteinander verbunden bleiben. Eine solche Ausführungsform dürfen also die Sicherungen im Sicherungskasten nicht ausgeschaltet werden.

In alternativen Ausführungsformen ist der Senderempfänger der Messgeräte und gegebenenfalls der Steuergeräte ein drahtloser Senderempfänger, der Datenaustausch unter Verwendung eines geeigneten Protokolls, beispielsweise des Wifi oder Bluetooth Protokolls, ermöglicht.

Die Auswertemittel der erfindungsgemäßen Anordnung sind in manchen Ausführungsformen, welche ein Steuergerät umfassen, in diesem angeordnet. Sie können aus einem dedizierten Hardwareauswerteeinheit bestehen, welche für einen Mikrochip und ein Programmspeicher mit entsprechender Auswertesoftware verfügt oder es wird eine Auswerteeinheit eingesetzt, in er die Auswertealgorithmen fest, wie beispielsweise in einem ASIC (Application Specific Integrated Circuit) oder abänderbar, wie in einem FPGA (Field Programmable Gate Array) eingeprägt sind.

In alternativen Ausführungsformen wird die Auswertung durch die Messgeräte gemeinschaftlich in einem Peer-To Peer Verfahren vorgenommen. Hierzu können ähnliche Auswertealgorithmen eingesetzt werden, wie auch bei der Verwendung eines Steuergerätes, nur das diese Steuereinheiten der Messgeräte gemeinschaftlich ausgeführt werden. Es kann dabei auch von allen Messgeräten ein Messgerät als Master ausgewählt werde, der die Auswertealgorithmen durchführt und die Ergebnisse an die anderen Messgeräte mittels der Datensendemittel mitteilt.

Eine weitere mögliche Ausgestaltung sieht vor, dass die Messgeräte jeweils ihre Messergebnisse des oder der jeweiligen Belastungstests an alle anderen registrierten Messgeräte senden, aber jedes der Messgeräte unabhängig voneinander die Auswertung vornimmt. Eine Ausgabe der Auswerteergebnisse kann den Benutzer dann von jedem der Messgeräte bei vorhanden sein entsprechender Anzeigemittel angezeigt werden. Alternativ können auch alle Auswerteergebnisse von Messgeräten an ein zentrales Gerät beispielsweise ein zu auserwähltes Messgerät oder ein Steuergerät mit oder ohne Messgerätfunktion weitergegeben und dort auf Übereinstimmung geprüft und angezeigt werden. Bei etwaigen Abweichungen der Auswerteergebnisse der einzelnen Messgeräte wird ein Datenabgleich durchgeführt. Wenn verifiziert wurde, dass alle Messgeräte die gleichen Messdaten der Auswertung zugrunde gelegt haben, wird eine erneute Auswertung veranlasst und die Messgeräte erneut verglichen. Bei verbleibender Abweichung der Ergebnisse, muss ein Fehler in den Auswertemitteln mindestens einer der Messgeräte vorliegen. Bei Verwendung von drei oder mehr Messgeräten, bei der die Mehrheit er Auswerteergebnisse übereinstimmen, können diese als die mi höchster Wahrscheinlichkeit richtigen angezeigt werden. Zusätzlich wird ein Hinweis auf ein Fehler in einen der Messgeräte angezeigt.

Als Startkriterium zum Beginn eines Messdurchgangs kann das Verbinden eines Messgeräts mit einem Anschlusspunkt, das Einschalten, falls vorhanden eines Steuergerätes oder einer Benutzereingabe auf einen der Messgeräte oder einem Steuergerät dienen.

Bevorzugt umfasst der von den Koordinationsmitteln der erfindungsgemä-ßen Anordnung erstellte Belastungszeitplan standartmäßig für jedes der registrierten Messgeräte genau ein Testzeitfenster, wobei die Testzeitfenster bevorzugt unmittelbar aneinander anschließen. Nach einer entsprechenden Benutzerkonfiguration kann bevorzugt jedoch auch ein Testregime ausgewählt werden, in dem die Koordinationsmittel in dem Belastungstestzeitplan des ersten Messdurchgangs bereits zeitlich Überlappungen der Testzeitfenster vorsehen.

Besonders bevorzugt wird in diesem Regime ein Testzeitplan erstellt, welcher für jedes Paar von Anschlusspunkten bzw. Messgeräten genau ein Überlappungszeitabschnitt vorsieht. Bei Beteiligung von lediglich zwei Anschlusspunkten bzw. Messgeräten sähe der Belastungstestzeitplan daher weiterhin lediglich zwei Testzeitfenster vor, welches jedoch in einem mittleren Teilabschnitt überlappen.

Bei drei zu zuordneten Anschlusspunkten muss jedoch einer der Anschlusspunkte bzw. das daran angeschlossene Messgerät ins zwei voneinander zeitlich getrennten Belastungszeitfenstern aktiv werden. Beispielsweise kann ein anhand seiner ID oder anhand des Einschaltzeitpunktes bestimmtes erstes Messgerät während eines ersten Zeitfensters einen Belastungstest durchführen, nach dessen Hälfte sich auch das zweite Messgerät zuschaltet, welches in einem dritten Zeitabschnitt nach Abschalten des ersten Messgerätes einen Belastungstest ohne Beteiligung der beiden anderen Messgeräte durchführt. In einem vierten Zeitabschnitt, welcher den letzten Abschnitt des Belastungstestzeitfensters des zweiten Messgerätes darstellt, schaltet sich das dritte Messgerät zu, sodass sich in diesem vierten Zeitabschnitt die Testpunkte zwei und drei gleichzeitig belastet werden. Nach Abschalten des zweiten Messgerätes wird in einem fünften Zeitabschnitt der dritte Anschlusspunktalleine vermessen, wovor sich in einem letzten sechsten, Zeitabschnitt das erste Messgerät nochmals zuschaltet um einen gemeinsamen Belastungstest an den Anschlusspunkten eins und drei durchzuführen. Dieser gibt also insgesamt sechs Zeitabschnitte von denen jeweils drei eine alleinige Messung eines Anschlusspunktes und die anderen drei eine paarweise Messung zweier der drei Anschlusspunkte darstellen.

In einer alternativen Ausführungsformen wird zunächst eine Einzelmessung aller beteiligten Anschlusspunkte durchgeführt, und nur im Falle von bei vorgegebener Messgenauigkeit nicht eindeutig zuordenbaren Anschlusspunkten wird beim zweiten Durchgang ein Belastungstests von Paaren von Anschlusspunkten durchgeführt. Bei einem solchen zweiten Durchgang kann auf Zeitabschnitte, in denen nur ein Messgerät aktiv ist, verzichtet werden, um eine Gesamtdauer des Belastungstestzeitplans des zweiten Durchgangs gering zu halten.

In weiterhin bevorzugten Ausführungsformen ist die erfindungsgemäße Anordnung außer zur Sicherungskreiszuordnung auch dazu eingerichtet, eine Phasenzuordnung der Anschlusspunkte vorzunehmen. Dies beispielsweise wie in der Anmeldung DE 10 2021 123 908.7 des Anmelders beschrieben, dadurch, dass jedes der Messgeräte an seinem Anschlusspunkt einen bestimmten Phasenwinkel oder einen bestimmten Zeitversatz der Nulldurchgänge der am Anschlusspunkt anliegenden Wechselspannung bestimmt und durch Vergleich Anschlusspunkte erkannt werden können, die an der gleichen Phase angeschlossen sind.

Weiterhin bevorzugt werden die von den Messgeräten bei den Belastungstestmessungen aufgenommenen Messwerte auch dazu verwendet, auch weitere Eigenschaften der Elektroinstallation zu berechnen. Darunter fallen beispielsweise Innenwiderstände der Anschlusspunkte, sowie Leitungswiderstände der mit den gemeinsamen mit den Anschlusspunkten führenden Leitungen der Elektroinstallation. Der Leitungswiderstand der gemeinsamen Leitung zweier Anschlusspunkte bestimmt sich aus dem bei Belastungstest eines ersten Anschlusspunkt an den anderen, unbelasteten Anschlusspunkt gemessenen Spannungsabfall als Quotient dieses Spannungsabfalls und dem durch den ersten, belasteten Abschlusspunkt fließenden Strom. Der Quotient des am ersten, belasteten Anschlusspunkt, gemessenen Spannungsabfalls und es dort fließenden Stromes ist gleich der Summe aus dem gemeinsamen Leitungswiderstand und den Innenwiderstandes des Anschlusspunkts, wobei zu diesem Innenwiderstand auch der Leitungswiderstand der nur zu diesem Anschlusspunkt gehörenden Leitung gezählt wird. Daher kann dieser Innenwiderstand durch Differenzbildung zwischen den besagten Quotienten des Spannungsabfalls am ersten Anschlusspunkt und des Stroms sowie der aus dem Spannungsabfalls des zweiten Anschlusspunkts berechneten gemeinsamen Leitungswiderstands ermittelt werden. Auf diese Weise kann für jedes Paar von Anschlusspunkten ein gemeinsamer Leitungswiderstand und für jeden Anschlusspunkt ein Innenwiderstand errechnet werden.

Zusätzlich zur bloßen Sicherungskreiszuordnung kann aus den Spannungsabfällen auch die Vernetzungsstruktur der Anschlusspunkte ermittelt werden, also wo die Anschlusspunktzuleitung sich verzweigen und welcher Leitungswiderstand den einzelnen Kanten des Verzweigungsbaums zugeordnet werden kann. Hierfür werden bei dem einen Sicherungskreis zugeordneten Anschlusspunkten für jeden dieser Anschlusspunkte die Spannungsabfälle der nicht belasteten Anschlusspunkte aufsteigend sortiert. Die Verzweigungsreihenfolge aus der Sicht des belasteten Anschlusspunktes ergibt sich dann aus dieser Sortierung, sprich je höher der an den unbelasteten Anschlusspunkten gemessenen Spannungsabfall desto höher ist der gemeinsame Leitungswiderstand und entsprechend desto näher liegt der unbelastete Anschlusspunkt im Verzweigungsbaum. Die Auswerteeinheit der erfindungsgemäßen Anordnung kann dazu vorbreitet sein, diesen Verzweigungsbaum und die einzelnen Abschnitten zugeordneten Leitungswiderstände aus den Messwerten zu berechnen. Hieraus ist auch eine genauerer Messwert für den Innenwiderstand der jeweiligen Anschlusspunkte ersichtlich, nämlich als der Widerstand des letzten, lediglich dem Anschlusspunkt selbst zugeordneten Kante des Baumes.

Die durch die Auswerteeinheit ermittelten zusätzlichen Informationen werden bevorzugt zusammen mit oder auch außer des Benutzers alternativ zu der Sicherungskreiszuordnung auf den Anzeigemitteln angezeigt.

Bei den Anzeigemitteln der erfindungsgemäßen Anordnung kann es sich um einen Display beispielsweise ein LCD- oder TFT Display handeln, welches einem der Messgeräte, einen Steuergerät oder allen Messgeräten enthalten ist. Alternativ oder zusätzlich kann die Anzeige der wesentlichen Sicherungskreiszuordnungsinformation auch in ein vereinfachter Form mit Hilfe von Lichtsignalen, beispielsweise einer Anzahl auf einer Anzeigeseite der Messgeräte vorhandenen, bevorzugt verschiedenfärbiger LEDs angezeigt werden, wobei das Aufleuchten einander entsprechender LEDs auf den Messgeräten eine Zuordnung zum gleichen Sicherungskreis bedeutet. Dieses vereinfachte Anzeigemittel ist also bevorzugt in jedes der Messgeräte integriert und kann eine detaillierte Anzeige von einem der Messgeräte oder Steuergerät ergänzen. Die maximal auf diese Weise für Benutzer unterscheidbare anzeigbare Zahl an Sicherungskreisen ist durch die Zahl der LEDs festgelegt. Werden beispielsweise vier LEDs eingesetzt, so können bis zu vier verschiedene Sicherungskreise unterscheiden werden.

Weiterhin verfügt eines, bevorzugt jedes, der Messgeräte der erfindungsgemäßen Anordnung über Schutzleitertestmittel, mit dem der korrekte Anschluss eines Schutzleiters überprüft werden kann. Ein derart gestaltetes Messgerät lassen sich besonders vielseitig zur Überprüfung aller relevanten Eigenschaften eines Abschlusspunktes sowie der die Anschlusspunkte dem aus Anschlusspunkt verbindender Elektroinstallation einsetzen.

Weitere Vorteile, Eigenschaften und Merkmale vorliegender Erfindung ergeben sich aus den nachfolgenden unter Bezugnahme auf die Figuren erläuterten Ausführungsbeispielen. Diese sollen die Erfindung lediglich erläutern und in keiner Weise einschränken.

Es zeigen:

Figur 1: In schematischer Darstellung eine Elektroinstallation mit mehreren Anschlüssen, an welche Geräte einer ersten Ausführungsform der erfindungsgemäßen Anordnung angeschlossen sind.

Figur 2A: Eine Vorderansicht eines Steuergeräts einer erfindungsgemäßen Anordnung gemäß der Ausführungsform gemäß der Figur 1.

Figur 2B: Ein zum Einstecken in einen Anschlusspunkt in Form einer Schukosteckdose geeignetes Messgerät einer erfindungsgemäßen Anordnung in überhöhter Seitenansicht.

Figur 3A: Eine Erläuterung des Messprinzips des erfindungsgemäßen Sicherungskreiszuordnungsverfahrens unter Verwendung einer erfindungsgemäßen Anordnung, in schematischer Darstellung mit sechs auf fünf Sicherungen aufgeteilte Anschlusspunkte.

Figur 3B:   Ein beispielhaftes Messergebnis für an den sechs Anschlusspunkten der in Figur 3A gezeigten Elektroinstallation angeschlossenen Messgeräte in Form von sich bei Durchführung der Belastungstest ergebender Spannungsverläufe.

Figur 3C:   Die aus Spannungsverläufen der Figur 3B im Zuge der Auswertung extrahierten zeitabschnittsweisen Spannungsabfälle und die sich daraus ergebende Sicherungskreiszuordnung.

Figur 4A:   Eine Schematische Darstellung einer Elektroinstallation ähnlich der aus Figur 3A mit dem Unterschied, dass die Verzweigung der zu dem Anschlusspunkten eines ersten Sicherheitskreises führenden Leitung kurz hinter dem Sicherungskasten erfolgt.

Figur 4B:   Ein Belastungstestzeitplan für einen ersten Messdurchgang und die sich daraus ergebenen Spannungsverläufe ähnlich der Figur 3B.

Figur 4C:   Die Spannungsabfälle während der vier Zeitabschnitte des ersten Belastungstestdurchgangs und der sich daraus ergebende vorläufige Sicherungskreiszuordnung.

Figur 4D:   Ein Belastungstestzeitplan für einen zweiten Messdurchgang mit sich überlappenden Testzeitfenstern zum Auflösen unklarer Zuordnungen sowie die sich daraus ergebenden Spannungsverläufe.

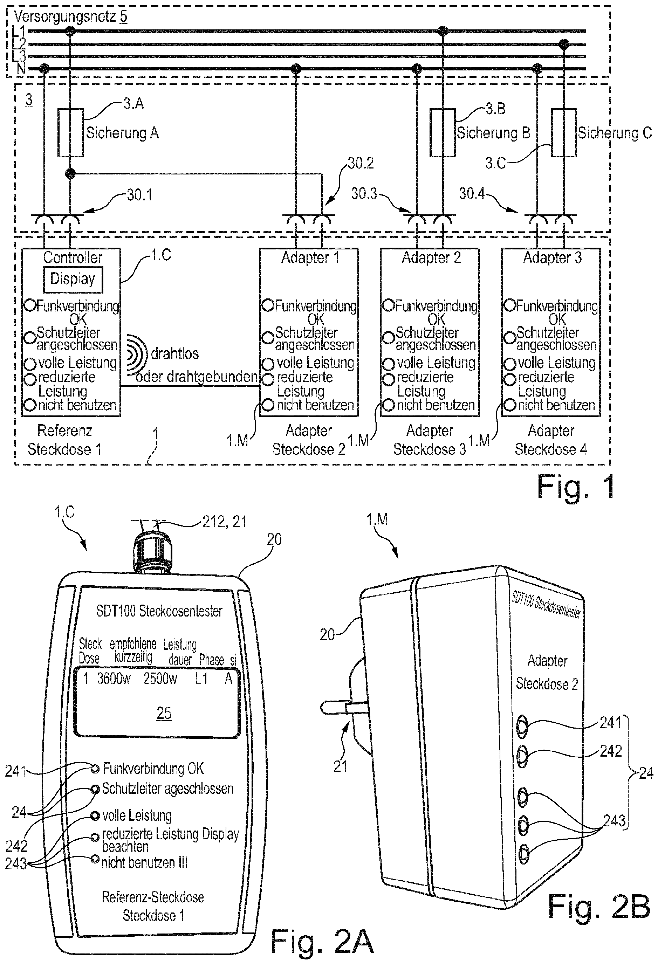

**Figur 1** zeigt eine schematische Übersicht einer Elektroinstallation 3 mit vier Anschlusspunkten 30.1 bis 30.4 welche auf drei Sicherungen 3.A, 3.B, und 3.C der Elektroinstallation 3 aufgeteilt sind. Die Sicherung 3.A ist an der Phase L1 des Versorgungsnetzes 5 angeschlossen und versorgt die Anschlusspunkte 30.1 und 30.2, die Sicherung 3.B ist an der gleichen Phase L1 wie die Sicherung 3.A angeschlossen und versorgt Anschluss 30.3 und die weitere Sicherung 3.C ist an die Phase L2 des Versorgungsnetzes 5 angeschlossen und versorgt den Anschlusspunkt 30.4. Jeder der vier Anschlusspunkte 30.1 - 4, welche hier schematisch als Steckdosen dargestellt sind, ist mit entsprechenden Anschlussmitteln versehenen Messgeräten 1.C, 1.M der erfindungsgemäßen Anordnung 1 verbunden. Die Messgeräte 1.C, 1.M verfügen über, nicht dargestellte, Belastungstestmittel und Datensendemittel mit denen sie einen Belastungstest des jeweiligen Anschlusspunktes 30.1 - 4 durchführen und die dabei aufgezeichneten Spannungs- bzw. Spannungsabfallmesswerte und Strommesswerte weitergeben können. Das Messgerät 1.C ist hierbei als Steuergerät ausgestaltet, welches zusätzlich zu den Anschlussmitteln, Belastungstestmittel und Datensendemitteln über Datenempfangsmittel, Koordinationsmittel und Auswertemittel verfügt, mit denen die Belastungstests des erfindungsgemäßen Messverfahrens koordiniert und die Messergebnisse ausgewertet werden können. Zusätzlich zu den übrigen Messgeräten 1.M verfügt das Steuergerät 1.S über ein Display 25, auf dem Auswertungsergebnisse einem Benutzer in Form von Text angezeigt werden kann.

Alle Messgeräte 1.C, 1.M verfügen über einen Satz an weiterer Anzeigemittel 24 in Form von LEDs, mittels derer dem Benutzer das korrekte Funktionieren der Anordnung sowie wichtige Eigenschaften der Anschlusspunkte angezeigt werden können. Eine erste LED 241 zeigt an, das die Funkverbindung zu dem Kontrollgerät 1.C bzw. vom Kontrollgerät 1.C zu den anderen Messgeräten 1.M, in folgendem Adapter genannt, eine ausreichende Datenübertragung zur Durchführung des erfindungsgemäßen Verfahrens ermöglicht. Das Aufleuchten einer zweiten LED 242 zeigt an, dass der an der Steckdose des jeweiligen Messgeräts vorhandene Schutzleiter vorschriftsmäßig und korrekt angeschlossen ist. Eine Gruppe von drei weiteren LEDs 243 gibt eine Indikation über die Belastbarkeit des Anschlusspunkts: bei aufleuchten der obersten, bevorzugt grünen, LED ist der Anschluss mit der maximalen für einen Hausanschlusspunkt zulässigen Leistung belastbar. In Deutschland sind dies üblicherweise 16 A welche bei der nominellen einphasigen Versorgungsspannung von 230V einer elektrischen Leistung 3600 Watt entsprechen. Bei Aufleuchten der zweiten, bevorzugt gelben, LED kann nur eine reduzierte Leistung abgerufen werden. Eine Empfehlung für die maximale Leistung, die an diesem Anschlusspunkt nicht überschritten werden sollte ermittelt die Anordnung, genauer die Auswertemittel des Steuergeräts 1.C, anhand der bei den Belastungstests gemessenen Strom- und Spannungswerten und daraus ermittelten Parameter der Elektroinstallation 3 und der Anschlusspunkte 30.1 - 4, wie die Leitungswiderstände der gemeinsamen Leitungen sowie Innenwiderständen der Anschlusspunkte. Diese Empfehlung kann dem Benutzer auf dem Display 25 des Steuergeräts 1.C in Form eines Leistungswertes angezeigt werden.

Illustriert ist dies in **Fig. 2A,** welche das Steuergerät 1.C der in Fig. 1 dargestellten bevorzugten Ausführungsform der erfindungsgemäßen Anordnung zeigt. Wie zu erkennen, werden in der ersten Zeile des im oberen Bereich der Vorderseite des Gehäuses 20 integrierten Displays 25 die Informationen Anschlusspunkt/Steckdosen-ID (dem Gerät zugeordnet), empfohlene Kurzzeitleistung (hierbei handelt es sich um die nominelle Leistung der Sicherung) sowie die empfohlene maximale Dauerleistung angezeigt. Zusätzlich ist noch die Phasenzuordnung relativ zu einer Referenzphase angezeigt. Bei der Referenzphase handelt es sich in bevorzugten Ausführungen um die Phase des Anschlusspunktes, mit dem das Steuergerät verbunden ist. Alternativ oder zusätzlich kann diese Standardauswahl auch vom Benutzer geändert und die Phase eines anderen Anschlusspunktes, an welchem eines der aktiven Messgeräte angeschlossen ist, als Referenzphase definiert werden.

Das Display ist hier wie dargestellt ein 4 zeiliges LCD Display. Um Informationen zu mehr als vier Anschlusspunkten gleichzeitig wiedergeben zu können, kann auch ein Display mit mehr Zeilen verwendet werden. Alternativ oder zusätzlich werden Eingabemittel zum Scrollen durch eine Liste von vermessenen Anschlusspunkten eingesetzt.

Es ist in dieser Ausführungsform vorgesehen, dass das Steuergerät 1.C wie die übrigen Messgeräte 1.M über Anschlussmittel zum Verbinden mit einem Anschlusspunkt, sowie Belastungstestmitteln für Belastungstests verfügt. Besonders bevorzugt ist das Funktionieren der Anordnung jedoch nicht davon abhängig, dass das Steuergerät 1.C auch tatsächlich mit einem der interessierenden, zu vermessenden Anschlusspunkte verbunden ist. D.h. das Steuergerät kann auch in einer bloßen Steuer- und Anzeigerolle betrieben werden. In anderen Ausführungsformen verfügt es nicht über Anschluss- oder Belastungstestmittel und ist immer auf eine reine Steuer- und Anzeigefunktionalität beschränkt.

Um das Steuergerät 1.C nicht in unmittelbarer Nähe zu dem Anschlusspunkt, mit dem es verbunden ist, ablesen oder bedienen zu müssen, umfassen seine Anschlussmittel 21 bevorzugt ein Kabel 212, an dessen Ende das eigentliche Verbindungsstück, beispielsweise ein Stecker, angebracht ist.

Die **Fig. 2B** zeigt Messgerät 1.M, hier auch Messadapter genannt, der in Fig. 1 schematisch illustrierten erfindungsgemäßen Anordnung 1. Die Vorderseite des quaderförmigen Gehäuses 20 umfasst bis auf das Display 25 die gleichen Anzeige-LEDs 24 wie das Steuergerät 1.C zum Anzeigen der Qualität der Funkverbindung, des Ergebnisses einer Schutzleiterprüfung sowie einer Belastbarkeitsprüfung.

Als Anschlussmittel ist auf der der Vorderseite mit den Anzeigemitteln 24 gegenüberliegenden Rückseite ein Schukostecker 21 integriert.

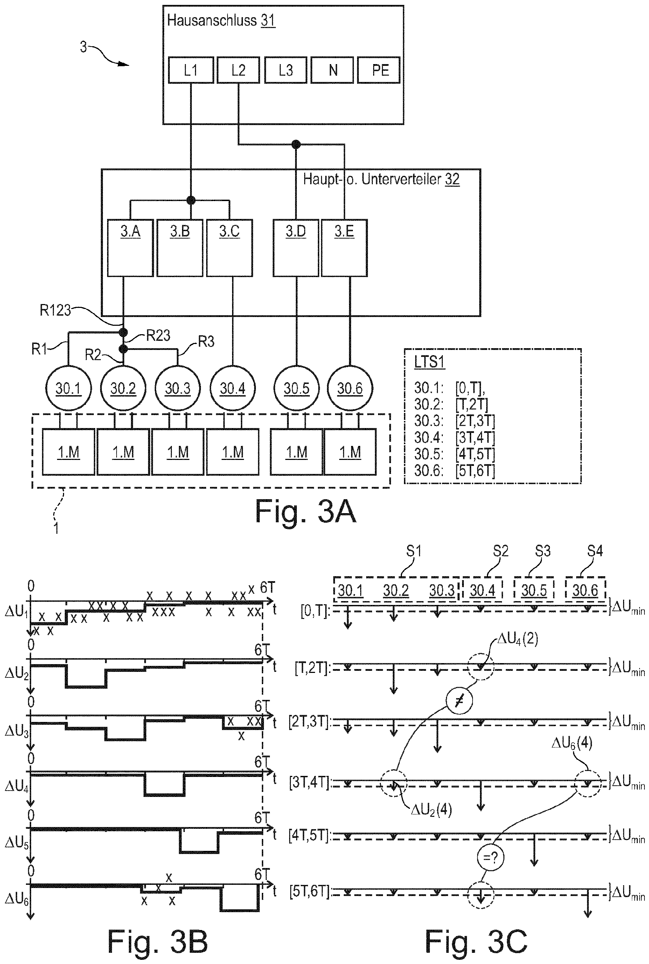

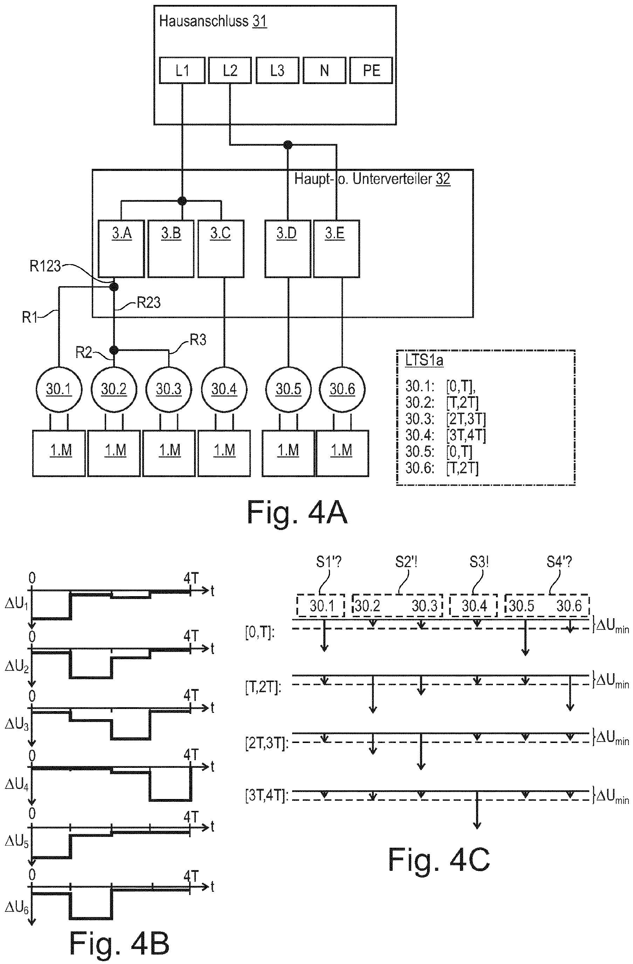

In den **Figuren 3A** - **3C** sowie **4A** - **4D** ist eine Ausführungsform des erfindungsgemäßen Sicherungskreiszuordnungsverfahrens illustriert. Dieses Verfahren kann mittels der erfindungsgemäßen Anordnung, beispielsweise einer Anordnung wie in den zuvor beschriebenen Figuren 1, 2A und 2B illustriert, ausgeführt werden.

**Fig. 3A** zeigt schematisch eine Elektroinstallation 3 mit einem Hausanschluss 31, in welchem die Phasen L1, L2, L3 einer Versorgungsspannung von einem externen Versorgungsnetz (hier nicht abgebildet) an die (interne) Elektroinstallation 3 übergeben werden. Die Phasen sind an einen beispielhaften Verteilerknoten 32 weitergegeben. Es können auch mehrere solcher Verteilerknoten 32 vorhanden sein, beispielsweise ein Haupt- und mehrere nachgeschaltete Unterverteiler. In dem Verteilerknoten oder auch davor verzweigen die sich vom Hausanschluss 31 kommenden Leiter und werden mehreren Sicherungen 3.A - E zugeführt. Von den fünf beispielhaft dargestellten Sicherungen, sind die Sicherungen 3.A, 3.B und 3.C der Phase L1 und die Sicherungen 3.D und 3.E der Phase L2 zugeordnet. In diesem Beispiel ist der Einfachheit keine der Phase L3 zugeordnete Sicherung gezeigt. In der Praxis wäre davon auszugehen, dass jede der Phasen L1 - L3 mindestens eine zugeordnete Sicherung aufweist, da der Leistungsbedarf der über die Elektroinstallation 3 versorgten Verbrauch aus Gründen der Versorgungsnetzstabilität möglichst gleichmäßig auf die drei Phasen aufgeteilt werden soll. Ebenfalls der Übersichtlichkeit halber wurde auf Darstellung der Verschaltung des Neutralleiters N und des Schutzleiters PE verzichtet. Dass und wie die Anschlusspunkte auch mit diesen über die Elektroinstallation verbunden sein müssen, ist dem Fachmann geläufig. Vom Verteilerknoten 32 führen Außenleiter zu mehreren, hier beispielhaft sechs, Anschlusspunkten 30.1 - 6, etwa Steckdosen, Lampenfassungen, Schaltern oder Anklemmpunkten zum direkten Anklemmen von unbeweglichen oder zumindest sehr selten bewegten Verbrauchern. Mit jedem der sechs Anschlusspunkte 30.1 - 6 ist ein schematisch angedeutetes Messgerät 1.M der erfindungsgemäßen Anordnung 1 verbunden.

Auf ein Startsignal hin, erstellen die Koordinationsmittel der Anordnung 1, welche als eine zentrale Steuereinheit eines als Steuergerät fungierenden der Messgeräte oder auch verteilt unter Anwendung einer kooperativen Steuerung der Messgeräte 1.M realisiert sein können, einen Belastungstestzeitplant LTS1. In der hier vorgestellten Ausführungsform des erfindungsgemäßen Verfahrens ist dies standardmäßig ein Zeitplan, in dem jedes der sechs Messgeräte einen von sechs unmittelbar aufeinander folgender Zeitfenster zugewiesen bekommt, wobei jedes Zeitfenster eine Dauer T aufweist.

Die Dauer T muss ausreichend lang sein, um mindestens einen Maximalwert der am Anschlusspunkt anliegenden Wechselspannung zu enthalten. Bei der in Deutschland gebräuchlichen 50 Hz Spannung dauert jede Spannungsperiode 20ms. Dementsprechend muss T mindestens 10 ms betragen um zumindest ein Spannungsmaximum oder -minimum in die Messung mit einzubeziehen. Bevorzugt ist T aber länger um mehrere Spannungsextremwerte in die Messung mit einzubeziehen und so die Messgenauigkeit zu erhöhen. Beispielsweise kann T eine, zwei, drei, fünf oder auch zehn Spannungsperioden umfassen und daher, bei 50 Hz Wechselspannung 20, 40, 60, 100 oder 200 ms, oder bei 60 Hz Wechselspannung, 16,7 ms, 33.3 ms, 50,0 ms, 83,3 ms oder 166,7 ms andauern.

Die während der Dauer des Belastungstests gemessenen Spannungsextremwerte werden mit vor Beginn der Tests ermittelten Spannungswerten im (kollektiv) unbelasteten Zustand, also ohne das eines der Messgeräte 1.M einen Belastungstest durchführt, verglichen und so Spannungsänderungswerte ΔU ermittelt. Diese werden mit Ausnahme von statistischen Abweichungen bei betragsmäßig kleinen Änderungen negativ sein, weswegen im Folgenden auch von den gemessenen Spannungsabfällen die Rede ist.

Der Abfall der am Anschlusspunkt gemessenen Spannung bei Belastung rührt durch den Widerstand bzw allgemein die Impedanz der zum jeweiligen Anschlusspunkt führenden Leitungen sowie den Innenwiderständen der Anschlusspunkte selbst her. In der **Fig. 3A** sind diese beispielhaft für die drei im Sicherungskreis der Sicherung 3.A liegenden Anschlusspunkte 30.1 - 3 eingezeichnet. Der allen Anschlusspunkten 30.1 - 3 gemeinsame Teil der Zuleitung von der Sicherung 3.A hat einen Widerstand R123 und der nach dem Abzweig der Leitung zum Anschlusspunkt 30.1, den Anschlusspunkten 30.2 und 30.3 gemeinsame Teil einen Widerstand R23. Die Widerstände R1, R2 und R3 beschreiben die Widerstände/Impedanzen, welche jeweils ausschließlich dem jeweiligen Anschlusspunkt 30.1, 30.2 bzw. 30.3 zuzuordnen sind, d.h. sie sind jeweils die Summe der Leitungs- und Innenwiderstände. Wird beispielsweise am Anschlusspunkt 30.1 ein Belastungstest durchgeführt, bei dem eine ohmsche Last RL auf den Anschlusspunkt geschaltet wird, fließt durch diesen Anschlusspunkt ein Strom, der sich nach dem Ohm'schen Gesetz als Quotient der Versorgungsspannung bei offenem Stromkreis, U0, und der Summe der in Reihe liegenden Widerstände R123, R1 und RL errechnet:

$$I_1 = \frac{U_0}{R_{123} + R_1 + R_\mathrm{L}}$$

Durch diesen Stromfluss vermindert sich die Spannung am Anschlusspunkt 30.1 um die an den Widerständen R123 und R1 abfallende Spannung. Der gemessene Spannungsabfall ist also

$$\Delta U_1(1) = I_1(R_{123} + R_1)$$

wobei ΔU_n(m) den Spannungsabfall am Anschlusspunkt 30.n bei (Einzel-)Belastung des Anschlusspunktes m bezeichnet.

Durch die beiden anderen im gleichen Sicherungskreis befindlichen Anschlusspunkte 30.2 und 30.3 fließt zwar bei Belastung lediglich des ersten Anschlusspunkts 30.1 kein Strom, dennoch ergibt sich durch die gemeinsame Zuleitung R123 einen Spannungsabfall von

$$\Delta U_2(1) = \Delta U_3(1) = I_1\, R_{123}$$

welcher, abhängig von R123, signifikant sein kann. Für Anschlusspunkte in anderen Sicherungskreisen ist hingegen in erster Näherung kein Spannungsabfall zu erwarten, da keine gemeinsame Zuleitung vorhanden ist. Anders ausgedrückt ist der gemeinsame Leitungswiderstand für diese anderen Anschlusspunkte 30.4 - 6 näherungsweise 0 Ohm, und somit ergibt sich an diesen Punkten auch ein Spannungsabfall von näherungsweise $I_1$*0 Ohm= 0 Volt.

Aus der Messung des Spannungsabfalls an einem Anschlusspunkt bei einem Belastungstests in Zusammensicht mit den Spannungsabfallwerten bei Belastungstests anderer Anschlusspunkte können daher zum einen qualitative Aussagen über die Verschaltung der Anschlusspunkte, insbesondere die Zuordnung zu einer Sicherung, aber darüber hinaus auch quantitative Aussagen wie die Leitungswiderstände ermittelt werden.

In den Figuren 3B und 3C ist dies beispielhaft für eine Anordnung 1 mit sechs an den sechs Anschlusspunkten 30.1 - 6 angeschlossenen Messgeräten illustriert. Die Figur 3B zeigt hierbei beispielhaft qualitative zu erwartende zeitliche Verläufe der Spannungsabfälle ΔU_n Anschlusspunkt 30.n während des Zeitintervalls [0, 6T], welches der Gesamtdauer des in **Fig. 3A** gezeigten Belastungstestzeitplans LTS1 entspricht. Die durchgezogenen linien entsprechen dabei den für das Messzeitfenster gemittelten Werten der am jeweiligen Anschlusspunkt anliegenden (sinusförmigen) Wechselspannung. Beispielsweise können die Spannungen bei den Phasenwinkeln 90° und 270°, welche den Extremwerten der Spannung entspricht, erfasst und explizit, also rechnerisch, gemittelt werden. Alternativ erfolgt eine Spannungsmessung mit einem zeitlich trägeren Spannungsmessgerät, bei dem die Mittelung inhärent erfolgt. In der Figur ist für den obersten Spannungsverlauf ΔU_1 des Anschlusspunktes 30.1 durchgehend sowie für ausgewählte Zeitabschnitte anderer Messpunkte in Form von Kreuzen eine Mittelung gemäß der ersten Methode angedeutet, wobei jedes Kreuz einem gemessenen Spannungsabfallwert entspricht.

Die relative Abweichung der Einzelmesswerte vom Mittelwert ist zur besseren Sichtbarkeit übertrieben groß dargestellt. In der Praxis wären nur geringe Fluktuationen im Bereich der Messgenauigkeit zu erwarten. Ausnahme hiervon sind bei Messung im laufenden Betrieb Änderungen im Betriebszustand anderer von der Elektroinstallation 3 versorgter, hier nicht dargestellter Verbraucher, welche ebenfalls Spannungsschwankungen verursachen. Sofern die dadurch verursachten Schwankungen einen signifikanten Bruchteil der Zeitfensterlänge T andauern, kann dies bei expliziter Mittelung anhand einer systematischen Abweichung der Einzelmesswerte spätestens bei der Auswertung erkannt und der Belastungstest wiederholt werden. Alternativ kann ein Messgerät 1.M auch während des Belastungstests solche Schwankungen und systematischen Abweichungen erkennen und den anderen Messgeräten und/oder dem Steuer-Messgerät dies mitteilen, worauf der Test abgebrochen und nach Einschwingen eines neuen stabilen Zustandes neu begonnen werden.

Die Art der Mittelung ist für vorliegende Erfindung nicht entscheidend. Wichtig ist lediglich die Genauigkeit und Präzision der Messung.

Der Belastungstestzeitplan LTS1 kann explizit allen Messgeräten mitgeteilt werden. Dies ist insbesondere in Ausführungsformen sinnvoll, in denen eine verteilte Auswertung der Ergebnisse erfolgt, beispielsweise jedes der Messgeräte 1.M die für den eigenen Anschlusspunkt 30.1 - 6 relevanten Widerstandswerte ermittelt, weil in diesem Fall alle Messgeräte 1.M die Information benötigen, in welchem Zeitabschnitt welcher Anschlusspunkt belastet wird. Für Anschlusspunkt 1 etwa R1, R13 und R123. R13 ist Fig. 3A in nicht eingezeichnet, weil bei der in gezeigten Verschaltung R13 = 0 (wenn man definitionsgemäß den allen drei Anschlusspunkten 30.1 - 3 gemeinsamen Leitungswiderstand R123 herausrechnet) gilt, was eine ausreichend lange und genaue Belastungstestmessung auch bestätigen würd. Alternativ kann auch lediglich eines der Messgeräte 1.M die Funktion eines zentralen Steuergeräts übernehmen, den Belastungstestzeitplan erstellen und den anderen Messgeräte lediglich deren jeweiliges Messzeitfenster mitteilen. Diese hätten dann also lediglich hinsichtlich der eigenen Messwerte Gewissheit, könnten aber keine vollständige Auswertung vornehmen.

Die Messergebnisse werden in diesen Ausführungsformen von den anderen Messgeräten 1.M an das die Steuerfunktion übernehmende Messgerät 1.M weitergegeben, welches Ergebnisse zusammenführt und die Auswertung vornimmt.

Wie aus **Fig. 3B** hervorgeht, zeigen die Anschlusspunkte 30.1 - 6 jeweils bei dem Belastungstest des daran angeschlossenen Messgeräts 1.M den größten Spannungsabfall, da hier der größte Vorwiderstand wirksam wird, welcher der Summe der gegebenenfalls gemeinsamen Leitungswiderstände (Anschlusspunkte 30.1-3) und in jedem Fall die einzelnen Widerstände entspricht.

In **Fig. 3C** sind die während eines Zeitfensters gemessenen auf eine der vorgenannten Arten gemittelten Spannungsabfallwerte in Form von Pfeilen dargestellt, wobei die Werte der einzelnen an der Messung beteiligten Anschlusspunkte 30.1 - 6 zur besseren Vergleichbarkeit nebeneinander angeordnet sind. Die obere, durchgezogene Linie entspricht hierbei einem Spannungsabfall/einer Spannungsänderung von 0 (beliebige Spannungseinheiten) die in geringem Abstand darunter eingezeichnete gestrichelte Linie einem gemittelten Spannungsabfall von $\Delta U_{min}$, was einer voreingestellten Signifikanzschwelle entspricht, welche oberhalb, bevorzugt deutlich, insbesondere um einen Faktor 2, 3 oder mehr, oberhalb der Messgenauigkeit bzw. -präzision liegen sollte, um durch statistische Fluktuationen verursachte Fehlzuordnungen zu vermeiden.

Entscheidend für die erfindungsgemäß gesuchte Sicherungskreiszuordnung sind aber die Spannungsabfallwerte eines Anschlusspunktes während Belastungstests der anderen Anschlusspunkte. Wie in den Figuren 3B und 3C dargestellt, zeigen die Spannungsabfallwerte der Gruppe der drei Anschlusspunkte 30.1 - 3 eine signifikanten Spannungsabfall auch bei Belastungstests eines der anderen Anschlusspunkte dieser Gruppe. Dies zeigt, dass hier recht große gemeinsame Leitungswiderstände R123, R23 vorhanden ist. Da der gesamte gemeinsame Leitungswiderstand für die beiden Anschlusspunkte 30.2 und 30.3 der Summe aus R123 und R23 entspricht, ist der Spannungsabfall an einem dieser beiden Anschlusspunkte bei Belastungstest des jeweils anderen höher als bei dem Belastungstest des dritten Anschlusspunktes 30.1 der Dreiergruppe. Dies ist an den Spannungsabfallverlaufsdiagrammen der **Fig. 3B** und vielleicht noch deutlicher an den Pfeildiagrammen der Fig. 3C ersichtlich. Die Anschlusspunkte 30.4 - 6 zeigen hingegen bei Belastungstests der Anschlusspunkte 30.1 - 3 keinen signifikanten Spannungsabfall (vgl. z.B. oberste drei Pfeildiagramme der **Fig. 3C**).

Bei der Auswertung im Rahmen des erfindungsgemäßen Verfahrens kann bereits anhand dieses qualitativen Verhaltens (signifikanter Spannungsabfall ja/nein) auf eine Zugehörigkeit zu einem gemeinsamen Sicherungskreis geschlossen werden. Entsprechend werden die Anschlusspunkte 30.1 - 3 einem Sicherungskreis zugeordnet, was in **Fig. 3B** durch die die drei Anschlusspunkte umfassende gestrichelte Box S1 illustriert ist. Die Benennung ist hierbei beliebig.

Ein Belastungstest eines der Anschlusspunkte 30.4 - 6 führt hingegen grundsätzlich weder bei den drei Anschlusspunkten 30.1 - 30.3 noch bei den Anschlusspunkten 30.4 - 6 untereinander zu signifikanten Spannungsabfällen (vgl. z.B. untere drei Pfeildiagramme der **Fig. 3C**). Beispielhafte Ausnahmen, anhand derer die weitergehende Eigenschaften der im Rahmen der Ausführungsform des erfindungsgemäßen Verfahrens eingesetzter Auswertetechniken illustriert werden sollen, bilden die Spannungsabfallwerte $\Delta U_2(4)$, $\Delta U_4(6)$, $\Delta U_6(4)$ (in Fig. 3C durch gestrichelte Kreise hervorgehoben). Aufgrund besonders großer statistischer Fluktuationen oder aufgrund eines externen Einflusses wie eine Zustandsänderung, etwa eine Leistungsbedarferhöhung, eines anderen Verbrauchers der Elektroinstallation 3, wurden hier signifikante Spannungsabfälle gemessen. Der signifikante Spannungsabfall $\Delta U_2(4)$ deutet für sich genommen auf die Zugehörigkeit des zweiten Anschlusspunkts 30.2 und des vierten Anschlusspunkts 30.4 zu einem gemeinsamen Sicherungskreis hin, was nach Fig. 3A ersichtlich eine Fehlzuordnung wäre. Diese wird bei der Auswertung gemäß vorliegender Ausführungsform des erfindungsgemäßen Verfahrens dadurch vermieden, dass zunächst der Spannungsabfallwert mit vertauschten Indizes, also $\Delta U_4(2)$, betrachtet wird. Falls wirklich beide Anschlusspunkte zum gleichen Sicherungskreis gehören und einen signifkanten gemeinsamen Leitungswiderstand haben, müsste der Spannungsabfall $\Delta U_4(2)$ mit $\Delta U_2(4)$ korreliert sein, konkret müsste sogar ein (etwa) gleich großer Spannungsabfall zu sehen sein. Dies ist hier aber nicht der Fall: $\Delta U_4(2)$ liegt deutlich unterhalb der Signifikanzschwelle $\Delta U_{min}$. Somit werden die Anschlusspunkte 30.2 und 30.4 bereits nach diesem ersten Korrelationstest korrekterweise verschiedenen Sicherungskreisen zugeordnet.

Der Vorbeschriebener erste Korrelationstest wird zuerst durchgeführt, weil nur so bei separaten Anschlusspunkten, also solchen, welche tatsächlich mit keinem anderen der gemessenen Anschlusspunkte in einem gemeinsamen Sicherungskreis liegen, eine Fehlzuordnung vermieden werden kann. Bei Anschlusspunkten, welche wie der zweite Anschlusspunkt 30.2 jedoch bereits verlässlich mit anderen Anschlusspunkten, hier 30.1 und 30.3, demselben Sicherungskreis zugeordnet werden können, kann in einem zweiten Korrelationstest geprüft werden, ob auch diese weiteren Anschlusspunkte mit dem oder den fraglichen Anschlusspunkt/en korrelierte signifikante Spannungsabfälle zeigen oder nicht. Vorliegend ist dies nicht der Fall: keiner der Spannungsabfälle $\Delta U_1(4)$, $\Delta U_3(4)$, $\Delta U_4(1)$ oder $\Delta U_4(3)$ ist signifikant. Weiterhin kann die Zuordnung zu einem gemeinsamen Sicherungskreis davon abhängig gemacht werden dass alle, oder zumindest die Mehrheit, dieser Spannungsabfallwerte signifikant ist. So kann eine Fehlzuordnung selbst dann vermieden werden, wenn einer oder sogar mehrere dieser Spannungsabfälle zufällig signifikant sein sollte.

Zusätzlich zu der in **Fig. 3C** durch die gestrichelten Boxen S1, S2, S3 und S4 gezeigten rein qualitativen Sicherungskreiszuordnung kann durch Ausführungsformen der erfindungsgemäßen Anordnung und bei Ausführungsformen des erfindungsgemäßen Verfahrens noch eine quantitative Auswertung erfolgen, welche die konkreten Werte der gemeinsamen und einzelnen Leitungswiderstände ermittelt und standardmäßig oder zumindest auf eine Benutzereingabe hin mittels der Anzeigemittel anzeigt.

Die Grundlage der Zuordnung zweier Anschlusspunkte zu demselben Sicherungskreis ist gemäß des Prinzips des erfindungsgemäßen Verfahrens das Vorhandensein eines signifikanten, also einen signifikanten wechselseitigen Spannungsabfall erzeugenden, gemeinsamen Leitungswiderstandes. Dies hängt mit der Länge sowie dem Querschnitt der gemeinsamen Leitungsstrecke zusammen. Es kann nun im Prinzip vorkommen, dass der gemeinsame Teil der Leitung einen sehr hohen Querschnitt oder, wahrscheinlicher, nur sehr kurz ist, sich die Zuleitungen zu den Anschlusspunkten also kurz hinter der Sicherung verzweigen. In diesen Fällen kann es, besonders bei einer recht hoch gewählten Signifikanzschwelle $\Delta U_{min}$, dazu kommen, dass der bei einem Einzeltest verursachte wechselseitige Spannungsabfall unterhalb der Signifikanzschwelle liegt. Bei der Auswertung würden beide Anschlusspunkte dann fälschlicherweise verschiedenen Sicherungskreisen zugeordnet. Unter Sicherheitsaspekten ist diese Fehlzuordnung kritischer als die umgekehrte Fehlzuordnung von tatsächlich in verschiedenen Sicherungskreisen liegenden Anschlusspunkten zu demselben Sicherungskreis, denn bei erster Fehlzuordnung geht der Benutzer ja davon aus, dass beide Anschlusspunkte jeweils mit dem vollen für eine Sicherung zulässigen Strom, z.B. 16 A, belastet werden können. Da die Anschlusspunkte aber tatsächlich im selben Sicherungskreis liegen, kann es so zu einer Überlastung der zugehörigen Sicherung kommen. Die Sicherung kann entweder auslösen, was auch schon ein Nachteil ist, da sie wieder aktiviert werden muss. Schlimmer wäre aber, wenn sie nicht auslöst, da durch eine dauerhafte Überlastung die Leitungen und besonders alte und korrodierte Kontaktstellen überhitzen und eine Brandgefahr darstellen können.

Es wird daher in bevorzugten Ausführungsformen der Erfindung vorgeschlagen, einen Belastungstestdurchgang durchzuführen, bei welchem mehrere Anschlusspunkte gleichzeitig belastet werden. Dies kann in Form eines zweiten Belastungstestdurchgangs nach der Durchführung eines ersten Belastungstestdurchgangs mit Einzelbelastungstests aller Anschlusspunkte erfolgen. Alternativ kann auch bereits der erste Testdurchgang Zeitabschnitte vorsehen, in denen mehrere Anschlusspunkte gleichzeitig getestet werden. Beispielsweise können für alle Paare von Anschlusspunkten gleichzeitige Testzeitfenster vorgesehen werden.

Alternativ kann auch lediglich eine bedarfsorientierter zweiter Belastungstestdurchgang durchgeführt werden, bei welchem nicht alle Paare oder Tripel oder höhere Tupel von Anschlusspunkten, sondern lediglich solche getestet werden, bei denen nach Auswertung des ersten Durchgangs von Einzelbelastungstests noch Unklarheiten bestehen.

In den **Figuren 4A** - **4D** wird eine solche Situation illustriert. Die in der **Fig. 4A** gezeigte Elektroinstallation 3 mit Hausanschluss 31 und Verteilerknoten 32 entspricht im Wesentlichen der aus Fig. 3A. Im Unterschied hierzu verzweigt sich jedoch die Zuleitung zum Anschlusspunkt 30.1 bereits kurz hinter der Sicherung 3.A, so dass der gemeinsame Leitungswiderstand R123 so niedrig ist das bei Einzelbelastungstests der Anschlüsse 30.1 und 30.2 und 30.3 nicht verlässlich wechselseitige signifikante Spannungsabfälle gemessen werden. Wie in **Fig. 4B** und besonders **4C** gezeigt, können beispielsweise von den vier den Anschlusspunkt 30.1 involvierenden wechselseitigen Spannungsabfallwerten nur einer, $\Delta U_3(1)$, (knapp) über der Signifikanzschwelle $\Delta U_{min}$, zwei, $\Delta U_1(2)$ und $\Delta U_1(3)$ liegt auf der Schwelle und der vierte, $\Delta U_2(1)$ darunter liegen. Weder alle, noch eine Mehrheit der wechselseitigen Spannungsabfallwerte ist also signifikant. Eine Zuordnung des Anschlusspunkts 30.1 zu demselben Sicherungskreis wie die Anschlusspunkte 30.2 und 30.3 ist also nicht möglich. Letztere beiden Anschlusspunkte können hingegen anhand der klaren, signifikanten wechselseitigen Spannungsabfälle demselben Sicherungskreis S2 zugeordnet werden.

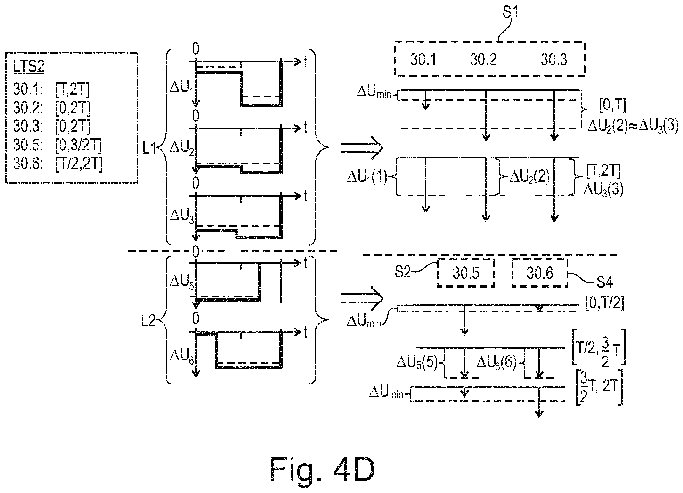

Bei der Zuordnung des Anschlusspunkts 30.1 verbleibt aber aufgrund der nahe an/auf bzw. in einem Fall auch über der Signifikanzschwelle liegenden wechselseitigen Spannungsabfallwerte mit den beiden anderen Anschlusspunkte 30.2 und 30.3 eine Zuordnungsunsicherheit. Um diese zu beseitigen wird in dem in **Fig. 4D** gezeigten zweiten Belastungstestzeitplan LTS2 in einem Zeitintervall [0, T] eine gleichzeitige Belastung der beiden Anschlusspunkte 30.2 und 30.3, oder im allgemeinen aller Anschlusspunkte, mit denen 30.1 möglicherweise in einem Sicherungskreis liegen könnte, vorgesehen. Als zusätzlicher Test kann, so wie hier im vorliegenden Zeitplan LTS2, auch ein Zeitfenster, hier [T, 2T] vorgesehen werden, in welchem alle drei Anschlusspunkte 30.1 -3, oder im allgemeinen alle fraglichen Belastungspunkte, welche in demselben Sicherungskreis liegen könnten, gleichzeitig belastet werden.

Wie in **Fig. 4D** anhand der zeitlichen Verläufe der gemittelten Spannungsänderungswerte sowie der dazugehörigen Pfeildiagramme für die Anschlusspunkte 30.1 - 3 erkennbar, ist bei gleichzeitiger Belastung von 30.2 und 30.3 am fraglichen Anschlusspunkt 30.1 ein nun signifikanter Spannungsabfall zu messen. Entscheidend, ist dieser in etwa doppelt so hoch wie bei vorhergegangenen Einzelmessung. Daher kann die Zuordnungsfrage bereits hiernach dahingehend entschieden werden, dass Anschlusspunkt 30.1 zu demselben Sicherungskreis gehören muss wie die Anschlusspunkte 30.2 und 30.3. Der Belastungstest aller drei Anschlusspunkte im Zeitfenster [T, 2T] dient als weitere Bestätigung: wie in Fig. 4D ersichtlich, zeigen die zeitlichen Verläufe der Spannungsabfälle $\Delta U_2$ und $\Delta U_3$ einen Sprung beim Zuschalten der Last an Anschlusspunkt 30.1.

Dies alles bestätigt das in Fig. 4D gezeigte endgültige Zuordnungsergebnis, welches die drei Anschlusspunkte 30.1 - 3 alle dem Sicherungskreis S1 zuordnet.

Zwei weitere vorteilhafte Weiterbildungen des erfindungsgemäßen Verfahrens werden ebenfalls in den Figuren 4A - 4D illustriert. Zum einen ist dies die Berücksichtigung der Phaseninformation. Wie in Fig. 4A zu sehen, sind die Sicherungen 3.D und 3.E, welche jeweils die Anschlusspunkte 30.5 bzw. 30.6 absichern, an der Phase L2 der Versorgungsspannung. In bevorzugten Ausführungformen bestimmt die erfindungsgemäße Anordnung in einem Schritt vor Erstellung des Belastungstestzeitplans für alle Messgeräte 1 .M die an dem jeweiligen Anschlusspunkt anliegende Phase der Versorgungsspannung. Anschlusspunkte an verschiedenen Phasen können nicht im gleichen Sicherungskreis liegen und die Zuordnung ist insoweit bereits eindeutig möglich. Zusätzlich kann durch dieses Wissen der Belastungstestzeitplan vorteilhaft gestrafft werden, denn Anschlusspunkte an verschiedenen Phasen können gleichzeitig ihre Belastungstests durchführen ohne sich gegenseitig zu beeinflussen.

Wie im beispielhaften Belastungstestzeitplan LTS1a der Figur 4A zu sehen, werden daher im Zeitfenster [0, T] die beiden Anschlusspunkte 30.1 (an der Phase L1) und 30.5 (an der Phase L2), sowie im Zeitfenster [T, 2T] die beiden Anschlusspunkte 30.2 (an der Phase L1) und 30.6 (an der Phase L2) gleichzeitig getestet. Die Gesamtdauer des Belastungstestzeitplans LTS1a der **Fig. 4A** ist daher 4T und ist somit vorteilhaft um ein Drittel kürzer als der die gleiche Zahl an Anschlusspunkten berücksichtigende Belastungstestzeitplan LTS1 der Fig. 3A.

Auch kann die Auswertung vereinfacht und beschleunigt werden, als wechselseitige Spannungsabfälle $\Delta U_n(m)$, mit $n \neq m$, für Anschlusspunkte 30.n, 30.m an verschiedenen Phasen L1 - L3 nicht betrachtet werden müssen. Die Auswertung beschränkt sich also vorteilhaft auf die Betrachtung von wechselseitigen Spannungsabfällen zwischen an der gleichen Phase hängenden Anschlusspunkten. Im vorliegenden Beispiel sind dies 30.1 -30.4 sowie 30.5 und 30.6.

Bei dem in den Figuren 4A-4D gezeigten Beispiel, liegen aufgrund zufälliger Schwankungen oder anderer Einflüsse beide wechselseitige Spannungsabfälle $\Delta U_5(6)$ und $\Delta U_6(5)$ über der Signifikanzschwelle, so dass eine Zuordnung zum gleichen Sicherungskreis S4 zunächst wahrscheinlich ist. Durch eine gleichzeitige Belastungstestung beider Anschlusspunkte 30.5 und 30.6 im Rahmen des zweiten Belastungstestdurchgangs nach dem Belastungstestzeitplan LTS2 zeigt sich dann aber, wie in **Fig. 4D** beispielhaft dargestellt, keine weitere Erhöhung des Spannungsabfalls gegenüber den im ersten Durchgang gemessenen Werten $\Delta U_5(5)$ bzw. $\Delta U_6(6)$. Somit können die beiden Anschlusspunkte korrekt verschiedenen Sicherungskreisen, in Fig. 4D mit S2 und S4 bezeichnet, zugeordnet werden.

Die Veranlassung zu einem zweiten Belastungstestdurchgang kann sich aus mehreren verschiedenen Kriterien ergeben, welche einzeln oder in Kombination anwendbar sind. Zum einen ist es möglich, wie in den obigen Beispielen, eine Konfidenz in die Zuordnung anhand einer Zählung der korrelierten wechselseitigen Spannungsabfälle der Einzelmessungen durchzuführen. Zeigen alle wechselseitigen Spannungsabfälle einer Gruppe von Anschlusspunkten eine signifikante Korrelation, kann diese Gruppe mit hoher Konfidenz demselben Sicherungskreis zugeordnet werden. Nicht korrelierte wechselseitige Spannungsabfälle führen zu einer Minderung der Konfidenz.

Bei einem Paar von (phasengleichen) Anschlusspunkten gibt es genau zwei wechselseitige Spannungsabfälle. Sind beide signifikant, so werden beide dem gleichen Sicherungskreis zugeordnet, sind beide nicht signifikant, werden beide mit hoher Konfidenz verschiedenen Sicherungskreisen. Ist nur einer signifikant, der andere aber nicht, so verbleibt eine Restunsicherheit. Kann diese nicht durch einen oben im Zusammenhang mit den **Figuren 3A** - **3C** erläuterten zweiten Korrelationstest ausgeräumt werden, kann ein zweiter Belastungstestdurchgang mit gleichzeitiger Belastung dieser beiden Anschlusspunkte vorgesehen werden.

Bei einem Tripel von Anschlusspunkten gibt es genau sechs wechselseitige Spannungsabfälle $\Delta U_n(m)$,

mit $n \neq m$. Wenn alle entweder signifikant oder nicht signifikant sind, ist eine klare Entscheidung mit sehr hoher Konfidenz möglich. Können zwei Paare einander zugeordnet werden, so ist mit recht hoher Konfidenz das ganze Tripel demselben Sicherungskreis zuzuordnen und es verbleibt nur eine kleine Restunsicherheit. In diesem Fall kann ein in manchen Ausführungsformen zweiter Belastungstestdurchgang für das Tripel von Anschlusspunkten vorgesehen werden, in anderen reicht die erreichte Konfidenz bereits aus. Falls jedoch keine paarweise Zuordnung möglich ist, wird in bevorzugten Ausführungsformen ein weiterer Belastungstestzeitplan erstellt, in dem für alle Paare des Tripels gleichzeitige Belastungstests vorgesehen sind. Das Vorhandensein oder nicht Vorhandensein einer Steigerung der Spannungsabfallwerte des jeweils unbelasteten Anschlusspunkts gegenüber den Einzeltestmesswerten zeigt dann mit sehr hoher Sicherheit an, ob und welche der drei Anschlusspunkte demselben Sicherungskreis zuzuordnen sind.

Diese Art der Auswertung kann ohne grundsätzliche Schwierigkeiten auf Quadrupel, Quintupel usw. erweitert werden.

Alternativ oder zusätzlich können weitere Signifikanzschwellen eingeführt werden, bei deren überoder unterschreiten ein zweiter Testdurchgang durchgeführt werden kann bzw. sollte. So kann beispielsweise eine Spannungsunsicherheit $\delta\Delta U$ definiert werden und wechselseitige Spannungsabfälle, welche in das Intervall $[\Delta U_{min} - \delta\Delta U, \Delta U_{min}]$ oder $[\Delta U_{min} - \delta\Delta U, \Delta U_{min} + \delta\Delta U]$ oder $[\Delta U_{min}, \Delta U_{min} + \delta\Delta U]$ fallen, werden in einem zweiten Belastungstestdurchgang überprüft. Genauer, kann, wenn für ein Paar, Tripel, usw. von Anschlusspunkten einer oder mehrere, beispielsweise eine Mehrheit oder ein anderer Anteil, beispielsweise mindestens ein Drittel oder ein Viertel, der wechselseitigen $\Delta U_n(m)$, mit $n \neq m$ in ein solches Intervall fällt, von den Koordinationsmitteln der erfindungsgemäßen Anordnung ein zweiter Belastungstest mit gleichzeitiger Belastung von zwei oder mehr der fraglichen Anschlusspunkte angeordnet werden.

## Bezugszeichenliste

| | |
|---|---|
| 1 | Anordnung |
| 1.M | Messgerät |
| 1.C | Steuergerät |
| 3 | Elektroinstallation |
| 31 | Hausanschluss |
| 32 | Verteilerknoten von 3 |
| 3.A - E | Sicherung eines Sicherungskreises von 3 |
| 30.1 - 6 | Anschlusspunkt |
| | |
| 5 | Versorgungsnetz |
| L1, L2, L3 | Phasen der von 5 bereitgestellten Versorgungsspannung |
| N | Neutralleiter von 5 |
| PE | Schutzleiter von 5 |
| | |
| S1', S2', S4' | mögliche Sicherungskreiszuordnung |
| S1 - S4 | endgültige Sicherungskreiszuordnung |
| $\Delta U$ | Spannungsabfall während Belastungstest |
| $\Delta U_n(m)$ | Spannungsabfall von 30.n bei Einzeltest von 30.m |
| $\Delta U_{min}$ | Signifikanzschwelle |
| | |
| LTS1[a],2 | Belastungstestzeitplan |
| T | Messzeitintervall |

## Patentansprüche

1. Anordnung (1) zur Zuordnung von Anschlusspunkten einer Elektroinstallation (3) zur Sicherungskreisen (S1 - S4) der Elektroinstallation (3) mit zwei oder mehr Messgeräten (1.M, 1.C), jedes umfassend:

  • Anschlussmittel (21) zum Anschluss an einen Anschlusspunkt (30.1 - 6) der Elektroinstallation (3),
  • Belastungstestmittel, zum Durchführen eines Belastungstests, wobei bei dem Belastungstest eine definierte feste oder variable Last ($R_L$) auf den Anschlusspunkt (30.1 - 6) geschaltet wird, und die Belastungstestmittel (22) weiterhin Spannungsmessmittel zum Messen einer an dem Anschlusspunkt (30.1 - 6) anliegenden Spannung und Strommessmittel zum Messen eines durch den Anschlusspunkt (30.1 - 6) fließenden Stroms aufweisen,
  • Sendemittel, um die bei den Belastungstest ermittelten Messwerte an andere Messgeräte (1.M) oder weitere Geräte (1.C) weiterzugeben, wobei die Anordnung (1) weiter umfasst:

  - Koordinationsmittel, um einen Belastungstestzeitplan (LTS1, LTS1a, LTS2) zu erstellen, welcher für alle Messgeräte (1.M, 1.C) ein oder mehrere Zeitfenster zur Durchführung eines Belastungstests des jeweiligen Anschlusspunktes (30.1 - 6) festlegt,
  - Auswertemittel, zur Bestimmung von die Sicherungskreiszuordnung enthaltenen Auswerteergebnissen aus den Messergebnissen der Messgeräte (1.M, 1.C), und
  - Anzeigemittel (25) um die Auswerteergebnisse mit der Sicherheitskreiszuordnung anzuzeigen,

  wobei die Anordnung (1) dazu vorbereitet ist

  • mittels der Koordinationsmittel einen Belastungstestzeitplan (LTS1, LTS1a, LTS2) zu erstellen, und bevorzugt eine gemeinsame Zeitbasis der Messgeräte (2) zu etablieren, insbesondere durch Synchronisieren interner Uhren oder eines Nulldurchgangszählers, und

- mittels der Messgeräte (1.M, 1.C) gemäß des Belastungstestzeitplans (LTS1, LTS1a, LTS2) Belastungstests der Anschlusspunkte (30.1 - 6) durchzuführen, wobei die Messgeräte (1.M) unter Verwendung ihrer Sendemittel während oder nach der Abarbeitung des Belastungszeitplans (LTS1, LTS1a, LTS2) die Messergebnisse den anderen Messgeräten (1.M) und/oder weiteren Geräten, insbesondere einem Steuergerät (1.C) der Anordnung (1) mitteilen,
- mittels der Auswertemittel aus den Messergebnissen der Messgeräte (1.M, 1.C) die gesuchte Zuordnung zu einem Sicherungskreis (S1 - S4) der Elektroinstallation (3) in einer Form zu ermitteln, aus hervorgeht, welche der Messgeräte (1.M) im gleichen Sicherungskreis (S1 - S4) befindlich sind,
- die Auswertungsergebnisse mittels der Anzeigemittel (25) anzuzeigen

**dadurch gekennzeichnet, dass**
die Auswertemittel dazu vorbereitet sind, die gesuchte Zuordnung zu einem der Sicherungskreise (S1 - S4) in der Art vorzunehmen, dass

- alle Anschlusspunkte (30.1 - 6), die bei einem Belastungstest eines ersten Anschlusspunktes einen signifikant, d. H. betragsmä-ßig oberhalb einer Signifikanzschwelle ($\Delta U_{min}$) liegend, von null verschiedenen wechselseitigen Spannungsabfall aufweisen den gleichen Schutzkreis zugeordnet werden, wie der erste Anschlusspunkt, und/oder
- für alle Teilmengen von Anschlusspunkten (30), d. H Paare, Tripel, usw. ein gemeinsamer Leitungswiderstand (R123, R23) ermittelt wird und als Zuordnung der Anschlusspunkte (30.1 - 6) zu den Sicherungskreisen (S1 - S4) diejenigen Menge von allen vermessenen Anschlusspunkten abdeckenden disjunkte Teilmengen der Anschlusspunkte angewählt wird, bei der der minimale, einer Teilgemenge zugeordnete gemeinsame Leitungswiderstand maximal ist.

2. Anordnung nach Anspruch 1, wobei die Koordinationsmittel, die Auswertemittel, und die Anzeigemittel (25) zentral in einem der Messgeräte (1.M) oder einem Steuergerät (1.C) der Anordnung (1) zusammengefasst sind.

3. Anordnung nach Anspruch 1, wobei jedes der Messgeräte der Anordnung (1) über eigene Koordinationsmittel, Auswertemittel und Anzeigemittel verfügt, wobei die Erstellung eines gemeinsamen Belastungstestzeitplans (LTS1, LTS1a, LTS2) sowie der Etablierung einer gemeinsamen Zeitbasis in einem Peer-to-Peer Verfahren erfolgt.

4. Anordnung nach einer der vorhergehenden Ansprüche, wobei die Anschlussmittel Stecker, Lampengewinde, oder Kabel mit Klemmen, insbesondere Krokodilklemmen, an den Enden umfassen.

5. Anordnung nach einer der vorhergehenden Ansprüche, wobei die Belastungstestmittel eine steuerbare Last, zum Beispiel einen elektrischen oder elektronischen Schalter wie einen Transistor, ein Relais, einen Triac oder einen Thyristor umfassen.

6. Anordnung nach einem der vorhergehenden Ansprüchen, wobei die Sendemittel jedes der Messgeräte (1.M) und/oder die Koordinationsmittel der Anordnung (1) einen Sendeempfänger umfassen, der drahtlos oder drahtgebunden, insbesondere über die Außenleiter der Elektroinstallation (3) kommunizierend, ausgestaltet ist.

7. Anordnung nach einer der vorhergehenden Ansprüche, wobei die Auswertemittel und/oder die Koordinationsmittel einen Mikroprozessor und einen Programmspeicher mit einem entsprechenden, die Auswertung von Messergebnissen und/oder Koordination einer Belastungstestmessung ermöglichenden Softwarecode umfassen.

8. Anordnung nach einem der vorhergehenden Ansprüche, wobei die Erstellung des Belastungstestzeitplans (LTS1, LTS1a, LTS2) und/oder die Synchronisierung der Messgeräte auf ein Starterereignis hin erfolgt, welches insbesondere das Verbinden eines der Messgeräte (1.M, 1.C) oder eines Steuergeräts (1.C) mit einem Anschlusspunkt, und/oder eine Benutzereingabe auf ein Eingabemittel eines der Messgeräte (1.M) oder eines Steuergeräts (1.M) der Anordnung (1) oder das Einschalten eines Steuergeräts (1.C) ist.

9. Anordnung nach einem der vorhergehenden Ansprüchen, wobei der Belastungstestzeitplan (LTS1, LTS1a, LTS2)

- eines ersten Belastungstestdurchgangs für jedes der angeschlossenen Messgeräte (1.M) mindestens ein Testzeitfenster vorsieht, in welchem dieses Messgerät (1.M) einen Belastungstest seines Anschlusspunktes (30.1 - 6) durchführt, und/oder

- eines weiteren Belastungstestdurchgangs nur für einen ausgewählten Teil der Messgeräten (1.M) ein Testzeitfenster vorsehen,

wobei die Testzeitfenster durch einen Anfangszeitpunkt und einen Endzeitpunkt, oder ein Anfangszeitpunkt und eine Dauer festgelegt ist, wobei Zeitpunkt und/oder Dauer als eine Zeit oder auch eine Zahl von Nulldurchgängen der am Anschlusspunkt anliegenden Wechselspannung gemessen werden.

10. Anordnung nach dem vorhergehenden Anspruch, wobei der Belastungstestzeitplan (LTS1, LTS1a, LTS2)

- jedem Messgerät (1.M) genau ein Testzeitfenster zugeordnet, welches sich mit keinem anderen Testzeitfenster des Belastungszeitplans überlappt, oder
- einigen oder allen Messgeräten (1.M) mehr als ein Testzeitfenster zuordnet, insbesondere derart, dass jedem Messgerät (1.M) eine Anzahl an Testzeitfenstern zugeordnet ist, welche der Zahl der Messgeräte weniger eins entspricht und die Testzeitfenster sich paarweise derart überlappen, dass für alle Paare von Messgeräten (2) genau ein Überlappungszeitraum vorkommt.

11. Anordnung nach einem der vorhergehenden Ansprüche wobei die Auswertemittel dazu vorbereitet sind, anhand der von den Messgeräten (1.M) bei den Belastungstest gemessenen, insbesondere gemittelten, Spannungsabfallwerten die Zugehörigkeit zu den Sicherungskreisen (S1 - S4) der Elektroinstallation (3) derart zu ermitteln, dass:

- alle Anschlusspunkte (30.n), die bei einem Belastungstest eines ersten Anschlusspunktes einen signifikant, also oberhalb einer Signifikanzschwelle liegend, von null verschiedenen wechselseitigen Spannungsabfall $\Delta U_n(m)$, $n \neq m$, aufweisen dem gleichen Sicherungskreis (S1 - S4) zugeordnet werden wie der erste Anschlusspunkt, und/oder
- für alle Teilmengen von Anschlusspunkten, d. H. Paaren, Tripeln usw., ein gemeinsamer Leitungswiderstandswert (R123, R23) ermittelt wird und als Zuordnung von Anschlusspunkten zu Sicherungskreisen diejenige alle Anschlusspunkte abdeckende Menge von disjunkten Teilmengen der Anschlusspunkte ausgewählt wird, bei der ein minimaler einer Teilmenge zugeordneter gemeinsamer Leitungswiderstand maximal ist.

12. Anordnung nach einem der vorhergehenden Ansprüche, bei der die Auswertemittel dazu vorbereitet sind,

- zwei Anschlusspunkte (30.1 - 6), die bei einem gleichzeitigen Belastungstest einen signifikant höheren wechselseitige Spannungsabfallwerte $\Delta U_n(m)$, $n \neq m$, aufweisen, als bei Einzeltests der jeweiligen Anschlusspunkte, dem gleichen Sicherungskreis zuzuordnen, und/oder
- alle Anschlusspunkte, welche bei einem gleichzeitigen Belastungstest zweier anderer, zum selben Sicherungskreis gehörender, Anschlusspunkte einen signifikant höheren Spannungsabfall aufweist als während Einzelbelastungstests nur jeweils eines der beiden anderen Anschlusspunkte dem gleichen Sicherungskreis zuzuweisen wie die beiden anderen Anschlusspunkte, und/oder
- die Leitungswiderstände der Anschlusspunkte zu bestimmen und zusammen mit der Sicherungskreiszuordnung dem Benutzer mittels der Anzeigemittel anzuzeigen,

wobei weiterhin die Auswertemittel und/oder die Koordinationsmittel dazu vorbereitet sind, bei der Erstellung des Belastungstestzeitplans und/oder der Auswertung der Messergebnisse eine Phasenzuordnung der jeweiligen Anschlusspunkte zu berücksichtigen..

13. Anordnung nach einem der vorhergehenden Ansprüche, wobei zumindest einer der Messgeräte, bevorzugt alle Messgeräte, über Schutzleitertestmittel verfügen.

14. Verfahren zur Zuordnung von Anschlusspunkten (30.1 - 6) einer Elektroinstallation (3) zu Sicherungskreisen (S1 - S4) der Elektroinstallation, umfassend

a) Verbinden von zwei oder mehr Messgeräten (1.M, 1.C) mit jeweils einem Anschlusspunkt (30.1 - 6) wobei jedes Messgerät (1.M, 1.C)

- Anschlussmittel (21), zum Anschließen an die Anschlusspunkte (30.1 - 6),
- Belastungstestmittel zum Durchführen von Belastungstests einschließlich Spannungsmessmitteln zum Messen einer an den Anschlusspunkt (30.1 - 6) anliegenden Spannung und Strommessmitteln zum Messen eines durch den Anschlusspunkt (30.1 - 6) fließenden Stromes,
- Datensendemittel zur Weitergabe der Messergebnisse des Belastungstests an andere Messgeräte (1.M) und/oder ein Steuergerät (1.C)

aufweist,

b) Erstellen eines Belastungstestzeitplans (LTS1, LTS1a, LTS2) mittels eines Koordinationsmittels, insbesondere ein Koordinationsmittel eines Steuergeräts (1.C) oder ein durch alle Messgeräte gemeinsam bereitgestellten, verteilten Koordinationsmittels,

c) Durchführung der Belastungstests gemäß dem Belastungstestzeitplan (LTS1, LTS1a, LTS2) durch jedes der Messgeräte (1.M, 1.C),

d) Übermittlung der Messergebnisse der Belastungstests an Auswertemittel, insbesondere ein Auswertemittel eines Steuergeräts (1.C) oder ein durch alle Messgeräte gemeinsam bereitgestellten, verteiltes Auswertemittel, oder Auswertemittel jedes der Messgeräte (1.M)

e) Auswertung der Messergebnisse der Belastungstest einschließlich Ermittlung der Sicherungskreiszuordnung,

f) Anzeige der Sicherungskreiszuordnung und gegebenenfalls weiterer Auswerteergebnisse mittels der Anzeigemittel (25),

**dadurch gekennzeichnet, dass**
die Auswertung der Messergebnisse in Schritt e dadurch erfolgt, dass

- alle Anschlusspunkte (30.1 - 6), die bei einem Belastungstest eines ersten Anschlusspunktes einen signifikant, d. H. betragsmäßig oberhalb einer Signifikanzschwelle ($\Delta U_{min}$) liegend, von null verschiedenen wechselseitigen Spannungsabfall aufweisen den gleichen Schutzkreis zugeordnet werden, wie der erste Anschlusspunkt, und/oder

- für alle Teilmengen von Anschlusspunkten (30), d. H Paare, Tripel, usw. ein gemeinsamer Leitungswiderstand (R123, R23) ermittelt wird und als Zuordnung der Anschlusspunkte (30.1 - 6) zu den Sicherungskreisen (S1 - S4) diejenigen Menge von allen vermessenen Anschlusspunkten abdeckenden disjunkte Teilmengen der Anschlusspunkte angewählt wird, bei der der minimale, einer Teilgemenge zugeordnete gemeinsame Leitungswiderstand maximal ist.

**Claims**

1. A system (1) for assigning connection points of an electrical installation (3) to fuse circuits (S1 - S4) of the electrical installation (3) with two or more measuring devices (1.M, 1.C), each comprising:

   - connection means (21) for connection to a connection point (30.1 - 6) of the electrical installation (3),
   - load testing means, for carrying out a load test, wherein during the load test a defined fixed or variable load (RL) is switched to the connection point (30.1 - 6), and the load testing means (22) also have voltage measuring means for measuring a voltage at the connection point (30.1 - 6) have applied voltage and current measuring means for measuring a current flowing through the connection point (30.1 - 6),

- transmission means to pass on the measured values determined during the stress test to other measuring devices (1.M) or other devices (1.C), wherein the system (1) further comprises:

   - coordination means to create a load test schedule (LTS1, LTS1a, LTS2), which specifies one or more time windows for all measuring devices (1.M, 1.C) to carry out a load test of the respective connection point (30.1 - 6),
   - evaluation means for determining the evaluation results contained in the fuse circuit assignment from the measurement results of the measuring devices (1.M, 1.C), and
   - display means (25) to display the evaluation results with the safety circuit assignment,

the system (1) is configured to

   • use the coordination means to create a load test schedule (LTS1, LTS1a, LTS2), and preferably to establish a common time base for the measuring devices (2), in particular by synchronizing internal clocks or a zero-crossing counter, and
   • use the measuring devices (1.M, 1.C) to carry out load tests of the connection points (30.1 - 6) according to the load test schedule (LTS1, LTS1a, LTS2), with the measuring devices (1.M) using their transmission means during or after processing the load schedule (LTS1, LTS1a, LTS2) to communicate the measurement results to the other measuring devices (1.M) and/or other devices, in particular a control device (1.C) of the system (1),
   • use the evaluation means to determine the desired assignment to a fuse circuit (S1 - S4) of the electrical installation (3) from the measurement results of the measuring devices (1.M, 1.C) in a form that shows which the measuring devices (1.M) are in the same fuse circuit (S1 - S4),
   • display the evaluation results using the display means (25),

**characterized in that**
the evaluation means are configured to make the desired assignment to one of the fuse circuits (S1 - S4) in such a way that

- all connection points (30.1 - 6) that exhibit a mutual voltage drop that is signicantly different from zero, i.e. a mutual voltage drop of a magnitude above a significance threshold ($\Delta$Umin), are as-sigend to the same fuse circuit as the first connection point, and/or
- for all subsets of connection points (30), i.e. pairs, triples, etc. a common line resistance (R123, R23) is determined and that set of disjoint subsets covering all measured connection points is selected as the assignment of the connection points (30.1 - 6) to the fuse circuits (S1 - S4) for which the smallest common line resistance assigned to any of its subsets is maximal.

2. The system according to claim 1, wherein the coordination means, the evaluation means, and the display means (25) are centrally combined in one of the measuring devices (1.M) or a control device (1.C) of the system (1).

3. The system according to claim 1, wherein each of the measuring devices of the system (1) has its own coordination means, evaluation means and display means, wherein the creation of a common load test schedule (LTS1, LTS1a, LTS2) and the establishment of a common time base takes place in a peer-to-peer procedure.

4. The system according to one of the preceding claims, wherein the connection means comprise plugs, lamp threads, or cables with clamps, in particular alligator clips, at the ends.

5. The system according to one of the preceding claims, wherein the load testing means comprises a controllable load, for example an electrical or electronic switch such as a transistor, a relay, a triac or a thyristor.

6. The system according to one of the preceding claims, wherein the transmitting means of each of the measuring devices (1.M) and/or the coordination means of the system (1) comprise a transceiver which is wireless or wired, in particular is designed to communicate via the outer conductor of the electrical installation (3).

7. The system according to one of the preceding claims, wherein the evaluation means and/or the coordination means comprise a microprocessor and a program memory with a corresponding software code which enables the evaluation of measurement results and/or coordination of a load test measurement.

8. The system according to one of the preceding claims, wherein the creation of the load test schedule (LTS1, LTS1a, LTS2) and/or the synchronization of the measuring devices takes place upon a start event, which in particular is the connecting of one of the measuring devices (1.M, 1. C) or a control device (1.C) with a connection point, and/or a user input on an input means of one of the measuring devices (1.M) or of a control device (1.M) of the system (1) or the switching on of a control device (1.C)..

9. The system according to one of the preceding claims, wherein the load test schedule (LTS1, LTS1a, LTS2)

   - of a first load test run provides at least one test time window for each of the connected measuring devices (1.M) in which time window the respective measuring device (1.M) carries out a load test of its connection point (30.1 - 6), and/or
   - of a further load test run provides a test time window for only for a selected part of the measuring devices (1.M),

   wherein the test time window is defined by a start time and an end time, or a start time and a duration, the time and/or duration being measured as a time or a number of zero crossings of the alternating voltage present at the connection point.

10. The system according to the preceding claim, wherein the load test schedule (LTS1, LTS1a, LTS2)

    - assigns to each measuring device (1.M) exactly one test time window which does not overlap with any other test time window in the load schedule, or
    - assigns more than one test time window to some or all measuring devices (1.M), in particular in such a way that each measuring device (1.M) is assigned a number of test time windows which corresponds to one less than the number of measuring devices and the test time windows overlap in pairs in such a way, that there is exactly one overlap period for all pairs of measuring devices (2).

11. The system according to one of the preceding claims, wherein the evaluation means are configured to determine the assignment to the fuse circuits (S1 - S4) of the electrical installation (3) based on the voltage drop values measured, in particular averaged, by the measuring devices (1.M) during the load test in such a way that:

    - all connection points (30.n) which, during a load test of a first connection point, have a mutual voltage drop $\Delta Un(m)$, $n \neq m$ that is significantly different from zero, i.e. above a significance threshold, are assigned to the same fuse circuit (S1 - S4) as the first connection point, and/or
- for all subsets of connection points, i.e. pairs, triples, etc., a common line resistance value (R123, R23) is determined and that set of disjoint subsets of connection points covering all connection points is selected as the assignment of connection points to the fuse circuits, for which a minimal common line resistance assigned to any of the subsets is maximum.

12. The system according to one of the preceding claims, in which the evaluation means are configured to

- assign two connection points (30.1 - 6), which exhibit a significantly higher mutual voltage drop value $\Delta Un(m)$, $n \neq m$, in a simultaneous load test than in individual tests of the respective connection points, to the same fuse circuit, and/or
- assign all connection points that exhibit a significantly higher voltage drop during a simultaneous load test of two other connection points belonging to the same fuse circuit than during individual load tests of only one of the two other connection points to the same fuse circuit as the two other connection points, and / or
- determine the line resistances of the connection points and to display them to the user together with the fuse circuit assignment using the display means,

wherein furthermore the evaluation means and/or the coordination means are configured to take into account a phase assignment of the respective connection points when creating the load test schedule and/or evaluating the measurement results.

13. The system according to one of the preceding claims, wherein at least one of the measuring devices, preferably all measuring devices, have protective conductor testing means.

14. A Method for assigning connection points (30.1 - 6) of an electrical installation (3) to fuse circuits (S1 - S4) of the electrical installation, comprising

a) connecting each of two or more measuring devices (1.M, 1.C) with a connection point (30.1 - 6), whereby each measuring device (1.M, 1.C) has

- connection means (21), for connecting to the connection points (30.1 - 6),
- load testing means for carrying out load tests, including voltage measuring equipment for measuring a voltage applied to the connection point (30.1 - 6) and current measuring equipment for measuring a current flowing through the connection point (30.1 - 6),
- data transmission means for passing on the measurement results of the load test to other measuring devices (1.M) and/or a control device (1.C),

b) creating a load test schedule (LTS1, LTS1a, LTS2) using a coordination means, in particular a coordination means of a control device (1.C) or a distributed coordination means provided jointly by all measuring devices,
c) carrying out the load tests according to the load test schedule (LTS1, LTS1a, LTS2) by each of the measuring devices (1.M, 1.C),
d) transmission of the measurement results of the load tests to evaluation means, in particular an evaluation means of a control device (1.C) or a distributed evaluation means provided by all measuring devices together, or evaluation means of each of the measuring devices (1.M),
e) evaluation of the measurement results of the load tests including determination of the fuse circuit assignment,
f) displaying the fuse circuit assignment and, if applicable, further evaluation results using the display means (25),

**characterized in that**
the evaluation of the measurement results in step e is carried out **in that** way that

- all connection points (30.1 - 6) that have a significantly non-zero mutual voltage drop, i.e. one that in terms of magnitude lies above a significance threshold ($\Delta umin$) are assigned to the same fuse circuit as the first connection point, and/or
- for all subsets of connection points (30), i.e. pairs, triples, etc. a common line resistance (R123, R23) is determined and that set of disjoint subsets of connection points covering all measured connection points is selected as the assignment of the connection points (30.1 - 6) to the safety circuits (S1 - S4) for which the smallest common line resistance assigned to any of its subsets is maximal.

**Revendications**

1. Système (1) pour attribuer des points de connexion d'une installation électrique (3) à des circuits des fusibles (S1 - S4) de l'installation électrique (3) avec deux ou plusieurs appareils de mesure (1.M, 1.C), comprenant chacun :

- des moyens de connexion (21) pour le raccordement à un point de connexion (30.1 - 6) de l'installation électrique (3),
- des moyens de test de charge, pour effectuer un test de charge, dans lesquels pendant le test de charge, une charge fixe ou variable (RL) définie est commutée vers le point de connexion (30.1 - 6), et les moyens de test de charge (22) comportent également une mesure de tension des moyens pour mesurer une tension au point de connexion (30.1 - 6) sont dotés de moyens de mesure de tension et de courant appliqués pour mesurer un courant circulant à travers le point de connexion (30.1 - 6),
- des moyens de transmission pour transmettre les valeurs mesurées déterminées lors du test d'effort à d'autres appareils de mesure (1.M) ou à d'autres appareils (1.C),

dans lequel le système (1) comprend en outre:

- des moyens de coordination pour créer un programme de test de charge (LTS1, LTS1a, LTS2), qui spécifie une ou plusieurs fenêtres horaires pour tous les appareils de mesure (1.M, 1.C) pour effectuer un test de charge du point de connexion respectif (30.1 - 6),
- des moyens d'évaluation pour déterminer les résultats d'évaluation contenus dans l'affectation aux circuits des fusibles à partir des résultats de mesure des appareils de mesure (1.M, 1.C), et
- des moyens d'affichage (25) pour afficher les résultats de l'évaluation avec l'affectation aux circuits des fusibles,

le système (1) étant configuré pour

• utiliser les moyens de coordination pour créer un programme des tests de charge (LTS1, LTS1a, LTS2), et de préférence pour établir une base de temps commune aux appareils de mesure (2), notamment par synchronisation d'horloges internes ou d'un compteur de passage à zéro , et
• utiliser les appareils de mesure (1.M, 1.C) pour effectuer des tests de charge des points de connexion (30.1 - 6) selon le programme de test de charge (LTS1, LTS1a, LTS2), avec les appareils de mesure (1 .M) utiliser leurs moyens de transmission pendant ou après le traitement du programme des tests de charge (LTS1, LTS1a, LTS2) pour communiquer les résultats de mesure aux autres appareils de mesure (1.M) et/ou à d'autres dispositifs, notamment un contrôleur dispositif (1.C) de le système (1),
• utiliser les moyens d'évaluation pour déterminer l'affectation souhaitée à un circuit de fusible (S1 - S4) de l'installation électrique (3) à partir des résultats de mesure des appareils de mesure (1.M, 1.C) sous une forme qui montre quelle des appareils de mesure (1.M) sont dans le même circuit de fusible (S1 - S4),
• afficher les résultats de l'évaluation à l'aide des moyens d'affichage (25),

**caractérisé en ce que**
les moyens d'évaluation sont configurés pour effectuer l'affectation souhaitée à l'un des circuits des fusibles (S1 - S4) de telle sorte que

- tous les points de connexion (30.1 - 6) qui présentent une chute de tension mutuelle significativement différente de zéro, c'est-à-dire une chute de tension mutuelle d'une ampleur supérieure à un seuil de significance ($\Delta U_{min}$), sont associés au même circuit des fusibles que le premier point de connexion, et/ou
- - pour tous les sous-ensembles de points de connexion (30), c'est-à-dire les paires, les triples, etc., une résistance de ligne commune (R123, R23) est déterminée et cet ensemble de sous-ensembles disjoints couvrant tous les points de connexion mesurés est sélectionné comme affectation de la connexion points (30.1 - 6) aux circuits des fusibles (S1 - S4) pour lequels la plus petite résistance de ligne commune attribuée à l'un de ses sous-ensembles est maximale.

2. Système selon la revendication 1, dans lequel les moyens de coordination, les moyens d'évaluation et les moyens d'affichage (25) sont regroupés de manière centralisée dans l'un des appareils de mesure (1.M) ou dans un dispositif de commande (1.C) du système (1).

3. Système selon la revendication 1, dans lequel chacun des dispositifs de mesure de l'agencement (1) possède ses propres moyens de coordination, moyens d'évaluation et moyens d'affichage, dans lequel la création d'un programme commun de tests de charge (LTS1, LTS1a, LTS2) et le l'établissement d'une base de temps commune s'effectue selon une procédure peer-to-peer.

4. Système selon l'une des revendications précédentes, dans lequel les moyens de connexion comprennent des fiches, des fils de lampe ou des câbles avec des pinces, notamment des pinces crocodiles, aux extrémités.

5. Système selon l'une des revendications précédentes, dans lequel les moyens de test de charge comprennent une charge contrôlable, par exemple un interrupteur électrique ou électronique tel qu'un transistor, un relais, un triac ou un thyristor.

6. Système selon l'une des revendications précédentes, dans lequel les moyens d'émission de chacun des appareils de mesure (1.M) et/ou les moyens de coordination du système (1) comprennent un émetteur-récepteur sans fil ou filaire , notamment est destiné à communiquer via le conducteur extérieur de l'installation électrique (3).

7. Système selon l'une des revendications précédentes, dans lequel les moyens d'évaluation et/ou les moyens de coordination comprennent un microprocesseur et une mémoire de programme avec un code logiciel correspondant qui permet l'évaluation de résultats de mesure et/ou la coordination d'un test de charge la mesure.

8. Système selon l'une des revendications précédentes, dans lequel la création du programme de test de charge (LTS1, LTS1a, LTS2) et/ou la synchronisation des appareils de mesure a lieu lors d'un événement de démarrage, qui est en particulier la connexion d'un des appareils de mesure (1.M, 1.C) ou un appareil de commande (1.C) avec un point de connexion, et/ou une saisie utilisateur sur un moyen d'entrée de l'un des appareils de mesure (1.M) ou de un dispositif de commande (1.M) du système (1) ou la mise en marche d'un dispositif de commande (1.C).

9. Système selon l'une des revendications précédentes, dans lequel le programme de test de charge (LTS1, LTS1a, LTS2)

    - d'un premier test de charge, il y a au moins une fenêtre temporelle de test pour chacun des appareils de mesure connectés (1.M), dans laquelle fenêtre temporelle l'appareil de mesure respectif (1.M) effectue un test de charge de son point de connexion (30.1 - 6), et/ou
    - un autre test de charge fournit une fenêtre de temps de test uniquement pour une partie sélectionnée des appareils de mesure (1.M),

dans lequel la fenêtre temporelle de test est définie par une heure de début et une heure de fin, ou une heure de début et une durée, le temps et/ou la durée étant mesurés comme un temps ou un nombre de passages par zéro de la tension alternative présente au point de connexion.

10. The système selon la revendication précédente, dans lequel le programme de test de charge (LTS1, LTS1a, LTS2)

    - attribue à chaque appareil de mesure (1.M) exactement une fenêtre temporelle de test qui ne chevauche aucune autre fenêtre temporelle de test dans le programme de charge, ou
    - attribue plusieurs fenêtres temporelles de test à certains ou à tous les appareils de mesure (1.M), en particulier de telle sorte que chaque appareil de mesure (1.M) se voit attribuer un nombre de fenêtres temporelles de test qui correspond à le nombre d'appareils de mesure moins un et les fenêtres temporelles de test se chevauchent par paires de telle sorte qu'il existe exactement une période de chevauchement pour toutes les paires d'appareils de mesure (2).

11. Système selon l'une des revendications précédentes, dans lequel les moyens d'évaluation sont configurés pour déterminer l'affectation aux circuits fusibles (S1 - S4) de l'installation électrique (3) sur la base des valeurs de chute de tension mesurées, notamment moyennées, par les appareils de mesure (1.M) pendant l'essai de charge de telle sorte que:

    - tous les points de connexion (30.n) qui présentent, lors d'un test de charge d'un premier point de connexion, une chute de tension mutuelle $\Delta U_n(m)$, $n \neq m$ significativement différente de zéro, c'est-à-dire supérieure à un seuil significatif, sont attribués au même circuit de fusible (S1 - S4) que le premier point de connexion, et/ou
    - pour tous les sous-ensembles de points de connexion, c'est-à-dire paires, triples, etc., une valeur de résistance de ligne commune (R123, R23) est déterminée et cet ensemble de sous-ensembles disjoints de points de connexion couvrant tous les points de connexion est sélectionné comme affectation de connexion pointe vers les circuits à fusibles, pour lequels une résistance minimale de ligne commune attribuée à l'un des sous-ensembles est maximale.

12. Système selon l'une des revendications précédentes, dans lequel les moyens d'évaluation sont configurés pour

    - attribuer deux points de connexion (30.1 - 6), qui présentent une valeur de chute de tension mutuelle significativement plus élevée $\Delta U_n(m)$, $n \neq m$, dans un test de charge simultané que dans des tests individuels des points de connexion respectifs au même circuit des fusibles, et/ou
    - attribuer tous les points de connexion qui présentent une chute de tension nettement plus élevée lors d'un test de charge simultané de deux autres points de connexion appartenant au même circuit de fusible que lors de tests de charge individuels d'un seul des deux autres points de connexion au même circuit des fusibles comme les deux autres points de connexion, et/ou

- déterminer les résistances de ligne des points de connexion et les afficher à l'utilisateur ainsi que l'affectation aux circuit des fusibles à l'aide des moyens d'affichage,

dans lequel en outre les moyens d'évaluation et/ou les moyens de coordination sont configurés pour prendre en compte une affectation de phase des points de connexion respectifs lors de la création du programme de test de charge et/ou de l'évaluation des résultats de mesure.

13. Système selon l'une des revendications précédentes, dans lequel au moins un des appareils de mesure, de préférence tous les appareils de mesure, comportent des moyens de test des conducteurs de protection.

14. Procédé pour attribuer des points de connexion (30.1 - 6) d'une installation électrique (3) à des circuits fdes fusibles (S1 - S4) de l'installation électrique, comprenant

a) connecter chacun de deux ou plusieurs appareils de mesure (1.M, 1.C) à un point de connexion (30.1 - 6), grâce à quoi chaque appareil de mesure (1.M, 1.C) possède

- des moyens de connexion (21), pour se connecter aux points de connexion (30.1 - 6),
- des moyens de test de charge pour effectuer des tests de charge, comprenant un équipement de mesure de tension pour mesurer une tension appliquée au point de connexion (30.1 - 6) et un équipement de mesure de courant pour mesurer un courant circulant à travers le point de connexion (30.1 - 6),
- des moyens de transmission de données pour transmettre les résultats de mesure du test de charge à d'autres appareils de mesure (1.M) et/ou à un appareil de contrôle (1.C),

b) créer un programme de tests de charge (LTS1, LTS1a, LTS2) à l'aide d'un moyen de coordination, notamment d'un moyen de coordination d'un dispositif de commande (1.C) ou d'un moyen de coordination distribué fourni conjointement par tous les appareils de mesure,

c) effectuer les tests de charge selon le programme de tests de charge (LTS1, LTS1a, LTS2) par chacun des appareils de mesure (1.M, 1.C),

d) transmission des résultats de mesure des tests de charge à des moyens d'évaluation, en particulier un moyen d'évaluation d'un dispositif de commande (1.C) ou un moyen d'évaluation réparti fourni par tous les appareils de mesure ensemble, ou des moyens d'évaluation de chacun des appareils de mesure (1.M),

e) évaluation des résultats de mesure des tests de charge, y compris la détermination de l'affectation à l'un des circuits des fusibles,

f) afficher l'affectation aux circuit de fusible et, le cas échéant, d'autres résultats d'évaluation à l'aide du moyen d'affichage (25),

**caractérisé en ce que**
l'évaluation des résultats de mesure à l'étape e est réalisée de telle sorte que

- tous les points de connexion (30.1 - 6) qui présentent une chute de tension mutuelle significativement different de zéro, c'est-à-dire qui, en termes d'amplitude, se situe au-dessus d'un seuil de signification ($\Delta U_{min}$), sont affectés au même circuit fusible que le premier point de connexion, et/ou

- pour tous les sous-ensembles de points de connexion (30), c'est-à-dire les paires, les triples, etc., une résistance de ligne commune (R123, R23) est déterminée et cet ensemble de sous-ensembles disjoints de points de connexion couvrant tous les points de connexion mesurés est sélectionné comme affectation des points de connexion (30.1 - 6) aux circuits des fusibles (S1 - S4) pour lesquels la plus petite résistance de ligne commune attribuée à l'un de ses sous-ensembles est maximale.

**Versorgungsnetz 5**

Controller
Display 1.C

O Funkverbindung OK
O Schutzleiter angeschlossen
O volle Leistung
O reduzierte Leistung
O nicht benutzen

drahtlos oder drahtgebunden

Referenz Steckdose 1

Adapter 1

O Funkverbindung OK
O Schutzleiter angeschlossen
O volle Leistung
O reduzierte Leistung
O nicht benutzen

Adapter Steckdose 2

Adapter 2

O Funkverbindung OK
O Schutzleiter angeschlossen
O volle Leistung
O reduzierte Leistung
O nicht benutzen

Adapter Steckdose 3

Adapter 3

O Funkverbindung OK
O Schutzleiter angeschlossen
O volle Leistung
O reduzierte Leistung
O nicht benutzen

Adapter Steckdose 4

Sicherung A — 3.A
Sicherung B — 3.B
Sicherung C — 3.C

**Fig. 1**

SDT100 Steckdosentester

| Steck Dose | empfohlene kurzzeitig | Leistung dauer | Phase | si |
|---|---|---|---|---|
| 1 | 3600w | 2500w | L1 | A |

25

O Funkverbindung OK
O Schutzleiter ageschlossen
O volle Leistung
O reduzierte Leistung Display beachten
O nicht benutzen !!!

Referenz-Steckdose
Steckdose 1

**Fig. 2A**

SDT100 Steckdosentester

Adapter
Steckdose 2

**Fig. 2B**

Fig. 3A

Fig. 3B

Fig. 3C

Hausanschluss 31

| L1 | L2 | L3 | N | PE |

Haupt- o. Unterverteiler 32

| 3.A | 3.B | 3.C | | 3.D | 3.E |

R123

R23

R1

R2 — R3

(30.1) (30.2) (30.3) (30.4) (30.5) (30.6)

| 1.M | 1.M | 1.M | 1.M | 1.M | 1.M |

LTS1a

30.1: [0,T],
30.2: [T,2T]
30.3: [2T,3T]
30.4: [3T,4T]
30.5: [0,T]
30.6: [T,2T]

## Fig. 4A

$\Delta U_1$
$\Delta U_2$
$\Delta U_3$
$\Delta U_4$
$\Delta U_5$
$\Delta U_6$

## Fig. 4B

S1'?   S2'!   S3!   S4'?

| 30.1 | 30.2 | 30.3 | 30.4 | 30.5 | 30.6 |

[0,T]:   }$\Delta U_{min}$

[T,2T]:   }$\Delta U_{min}$

[2T,3T]:   }$\Delta U_{min}$

[3T,4T]:   }$\Delta U_{min}$

## Fig. 4C

Fig. 4D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102021123908
- US 4121152 F, Hale
- US 6163144 A
- US 20160274174 A1
- US 20070139055 A1
- US 9552446 B2
- WO 9961928 A

- WO 0026679 A
- US 8018219 B2
- US 20140333324 A1
- US 9857414 B1
- US 20100085894 A1
- US 9354256 B1